# EUROPEAN PATENT APPLICATION

(11) **EP 4 815 658 A1**
(43) Date of publication of application: **30.09.2026**
(21) Application number: 26163589.0
(22) Date of filing: 10.03.2026
(51) Int. Cl.: H10B 12/00

(54) **SEMICONDUCTOR DEVICE INCLUDING ACTIVE PATTERN AND CONDUCTIVE SHIELD STRUCTURE**

(30) Priority: 25.03.2025 KR 20250037986
(71) Applicant: Samsung Electronics Co., Ltd., Suwon-si, Gyeonggi-do 16677 (KR)
(72) Inventor: JEONG, Moonyoung, 16677 Suwon-si (KR); CHOI, Jaehyun, 16677 Suwon-si (KR)
(74) Representative: Marks & Clerk LLP

(57) **Abstract**

A semiconductor device includes first and second bit lines each extending in a first direction and adjacent to each other in a second direction perpendicular to the first direction; first and second active patterns each including a first region, a second region, and a channel region between the first and second regions, wherein the first region of the first active pattern is connected to the first bit line in a third direction perpendicular to the first and second directions, and the first region of the second active pattern is connected to the second bit line in the third direction; a word line facing the channel regions of the first and second active patterns; and a conductive shield structure disposed between the first bit line and the second bit line, and between the first region of the first active pattern and the first region of the second active pattern.

## Description

### BACKGROUND

Example embodiments of the present disclosure relate to a semiconductor device including an active pattern and a conductive shield structure, and a method of manufacturing a semiconductor device.

Research has been conducted to reduce the sizes of elements included in a semiconductor device and to improve performance thereof. For example, in a Dynamic Random Access Memory (DRAM), research to reliably and stably form elements having reduced sizes has been conducted, but as the sizes of elements are reduced, dispersion properties of a semiconductor device may be deteriorated.

### SUMMARY

An example embodiment of the present disclosure is to provide a semiconductor device having improved performance.

An example embodiment of the present disclosure is to provide a method of manufacturing the semiconductor device.

According to an example embodiment of the present disclosure, a semiconductor device includes first and second bit lines each extending in a first direction and adjacent to each other in a second direction perpendicular to the first direction; first and second active patterns each including a first region, a second region, and a channel region between the first and second regions, wherein the first region of the first active pattern is connected to the first bit line in a third direction perpendicular to the first and second directions, and the first region of the second active pattern is connected to the second bit line in the third direction; a word line facing the channel regions of the first and second active patterns; and a conductive shield structure disposed between the first bit line and the second bit line, and between the first region of the first active pattern and the first region of the second active pattern.

According to an example embodiment of the present disclosure, a semiconductor device includes first and second bit lines each extending in a first direction and adjacent to each other in a second direction perpendicular to the first direction; first and second active patterns each including a first region, a second region, and a channel region between the first and second regions, wherein the first region of the first active pattern is connected to the first bit line in a third direction perpendicular to the first and second directions, and the first region of the second active pattern is connected to the second bit line in the third direction; a word line facing the channel regions of the first and second active patterns; and a conductive shield structure disposed between the first bit line and the second bit line, and between the first region of the first active pattern and the first region of the second active pattern, wherein the conductive shield structure includes a first shield pattern between the first region of the first active pattern and the first region of the second active pattern; and a second shield pattern between the first and second bit lines. The first shield pattern includes a first material having a first work function. The second shield pattern includes a second material having a second work function. The second work function is different from the first work function.

According to an example embodiment of the present disclosure, a semiconductor device includes a first structure including cell active patterns, bit lines, word lines, and a conductive shield structure; and a second structure disposed on and bonded to the first structure, wherein the second structure includes a bit line sense amplifier electrically connected to the bit lines, a sub-word line driver electrically connected to the word lines, and a voltage control circuit electrically connected to the conductive shield structure, wherein each of the bit lines extends in a first direction, wherein the bit lines include first and second bit lines adjacent to each other in a second direction perpendicular to the first direction, wherein each of the active patterns includes first and second source/drain regions spaced apart from each other in a third direction, and a channel region between the first and second source/drain regions, wherein the third direction is perpendicular to the first and second directions, wherein the word lines face the channel regions of the active patterns adjacent to the word lines, wherein the active patterns include a first active pattern connected to the first bit line and a second active pattern connected to the second bit line, wherein the first source/drain region of the first active pattern is connected to the first bit line in the third direction, wherein the first source/drain region of the second active pattern is connected to the second bit line in the third direction, and wherein the conductive shield structure includes a first shield pattern disposed between the first source/drain region of the first active pattern and the first source/drain region of the second active pattern.

According to an example embodiment of the present disclosure, a method of manufacturing a semiconductor device includes forming first and second active patterns; forming a word line facing the first and second active patterns; forming a first bit line connected to the first active pattern and a second bit line connected to the second active pattern; and forming a conductive shield structure having at least a portion disposed between the first and second bit lines. Each of the first and second bit lines extends in a first direction, the first bit line and the second bit line are adjacent to each other in a second direction perpendicular to the first direction, each of the first and second active patterns includes a first region, a second region, and a channel region between the first and second regions, the first region of the first active pattern is connected to the first bit line in a third direction perpendicular to the first and second directions, the first region of the second active pattern is connected to the second bit line in the third direction, the word line faces the channel regions of the first and second active patterns, and the conductive shield structure is formed between the first bit line and the second bit line, and between the first region of the first active pattern and the first region of the second active pattern.

A portion of the conductive shield structure may be formed between the channel region of the first active pattern and the second bit line, and between the channel region of the second active pattern and the first bit line.

The conductive shield structure may include a first shield pattern disposed between the first region of the first active pattern and the first region of the second active pattern, and a second shield pattern disposed between the first bit line and the second bit line.

The first shield pattern may have a first surface in contact with the second shield pattern and a second surface opposing the first surface in the third direction.

The first shield pattern may include a first material having a first work function, the second shield pattern may include a second material having a second work function. The second work function may be greater than the first work function.

The second shield pattern may be spaced apart from the first shield pattern in the third direction.

The method may further include forming a first dielectric layer between the conductive shield structure and the first region of the first active pattern, and between the conductive shield structure and the first region of the second active pattern, and forming a second dielectric layer between the conductive shield structure and the first bit line, and between the conductive shield structure and the second bit line.

The first dielectric layer and the second dielectric layer may have different dielectric constants.

A dielectric constant of the first dielectric layer may be greater than a dielectric constant of the second dielectric layer.

A minimum width of the channel region of the first active pattern may be greater than a minimum width of the first region of the first active pattern in the second direction.

Each of the first and second active patterns may further include at least one of a first offset region between the channel region and the first region and a second offset region between the channel region and the second region.

The word line may not face the first and second offset regions.

Each of the first and second regions may have N-type conductivity.

Each of the channel region, the first offset region, and the second offset region may be an undoped region.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIGS. 1, 2, and 3 are diagrams illustrating a semiconductor device according to example embodiments of the present disclosure;
FIG. 4 is a diagram illustrating a semiconductor device according to example embodiments of the present disclosure;
FIG. 5 is a diagram illustrating a semiconductor device according to example embodiments of the present disclosure;
FIGS. 6A and 6B are diagrams illustrating a semiconductor device according to example embodiments of the present disclosure;
FIG. 7 is a diagram illustrating a semiconductor device according to example embodiments of the present disclosure;
FIG. 8 is a diagram illustrating a semiconductor device according to example embodiments of the present disclosure;
FIG. 9 is a diagram illustrating a semiconductor device according to example embodiments of the present disclosure;
FIG. 10 is a diagram illustrating a semiconductor device according to example embodiments of the present disclosure;
FIG. 11 is a diagram illustrating a semiconductor device according to example embodiments of the present disclosure;
FIG. 12 is a diagram illustrating a semiconductor device according to example embodiments of the present disclosure;
FIGS. 13, 14, and 15 are diagrams illustrating a semiconductor device according to example embodiments of the present disclosure;
FIG. 16A is a diagram illustrating a semiconductor device according to example embodiments of the present disclosure;
FIG. 16B is a diagram illustrating a semiconductor device according to example embodiments of the present disclosure;
FIG. 16C is a diagram illustrating a semiconductor device according to example embodiments of the present disclosure;
FIG. 16D is a diagram illustrating a semiconductor device according to example embodiments of the present disclosure;
FIG. 16E is a diagram illustrating a semiconductor device according to example embodiments of the present disclosure;
FIGS. 17, 18, and 19 are diagrams illustrating a semiconductor device according to example embodiments of the present disclosure;
FIG. 20 is a flowchart illustrating a method of manufacturing a semiconductor device according to example embodiments of the present disclosure; and
FIGS. 21A, 21B, 22A, 22B, 23A, 23B, 24A, 24B, 25A, and 25B are diagrams illustrating a method of manufacturing a semiconductor device according to example embodiments of the present disclosure.

### DETAILED DESCRIPTION

Hereinafter, embodiments of the present disclosure will be described as follows with reference to the accompanying drawings.

Hereinafter, terms such as "upper," "intermediate" and "lower" may be replaced with other terms, such as "first," "second" and "third," to describe elements in the example embodiments. The terms such as "first," "second" and "third" may be used to describe various elements, but the elements are not limited by the terms, and a "first element" may be referred to as a "second element." In the example embodiments, terms such as "lower," "upper," "upper end" and "lower end" may be described based on the drawings. The terms "lower portion," "upper portion," "upper end," and "lower end" are described based in the drawings.

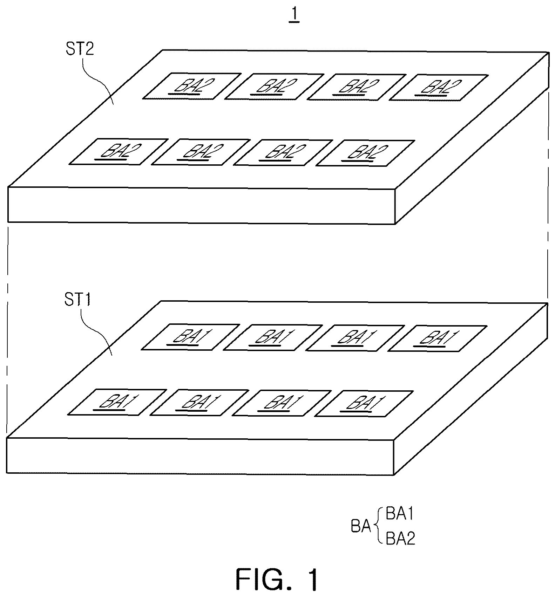

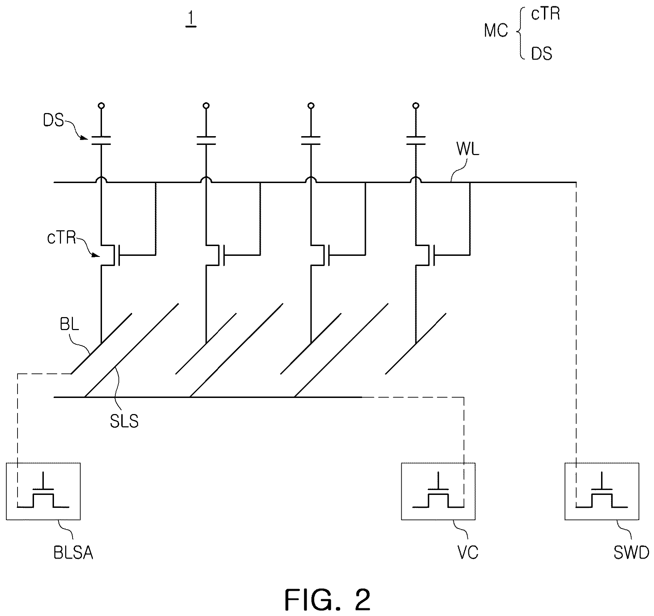

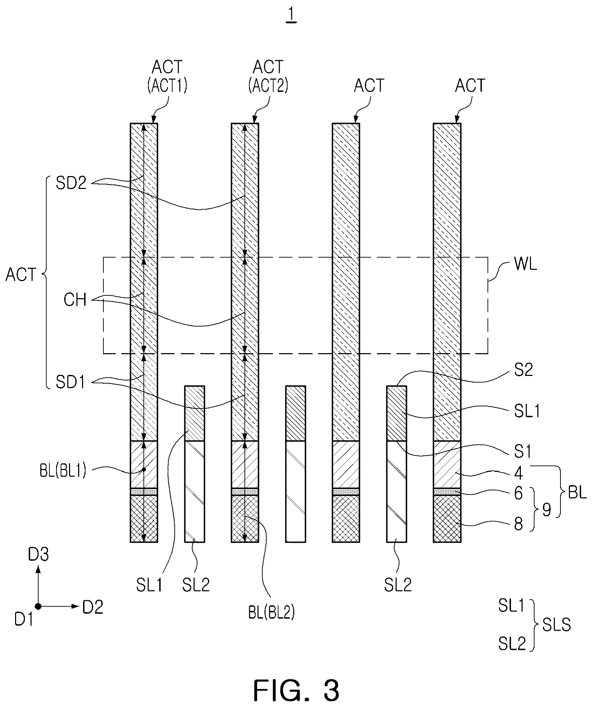

A semiconductor device according to example embodiments will be described with reference to FIGS. 1, 2, and 3. In FIGS. 1 to 3, FIG. 1 is a perspective diagram illustrating a semiconductor device according to an example embodiment, FIG. 2 is a diagram illustrating a semiconductor device including a circuit according to an example embodiment, and FIG. 3 is a schematic diagram illustrating a cross-sectional view of a semiconductor device in a second direction D2 and a third direction D3 according to an example embodiment.

Referring to FIGS. 1, 2, and 3, a semiconductor device 1 according to an example embodiment may include a first structure ST1 and a second structure ST2 on the first structure ST1. The first structure ST1 and the second structure ST2 may be bonded to each other by a wafer bonding process.

In an example, in the first structure ST1 and the second structure ST2, a dielectric layer of the first structure ST1 and a dielectric layer of the second structure ST2 may be bonded to each other by a dielectric-dielectric bonding process.

In an example, the first structure ST1 and the second structure ST2 may be bonded to each other by bonding the dielectric layer of the first structure ST1 and the dielectric layer of the second structure ST2 to each other by a hybrid bonding process including metal-metal bonding and dielectric-dielectric bonding, and bonding a metal layer (e.g., a copper layer) of the first structure ST1 and the metal layer (e.g., the copper layer) of the second structure ST2 to each other.

The semiconductor device 1 may include a plurality of banks BA. Each of the plurality of banks BA may include a first bank region BA1 in the first structure ST1 and a second bank region BA2 in the second structure ST2.

The first bank region BA1 of the first structure ST1 may include memory cells MC, bit lines BL connected to the memory cells MC, word lines WL connected to the memory cells MC, and a conductive shield structure SLS.

Each of the memory cells MC may include a cell transistor cTR and a data storage structure DS. The data storage structure DS may be a cell capacitor which may store data in a memory such as a DRAM.

The second bank region BA2 of the second structure ST2 may include bit line sense amplifiers BLSA electrically connected to the bit lines BL, sub-word line drivers SWD electrically connected to the word lines WL, and a voltage control circuit VC electrically connected to the conductive shield structure SLS.

Each of the bit lines BL may extend in the first direction D1. The bit lines BL may include a first bit line BL1 and a second bit line BL2 adjacent to each other in the second direction D2 perpendicular to the first direction D1.

Each of the first bit line BL1 and the second bit line BL2 may include a first material layer 4 and a second material layer 9 vertically aligned. The first material layer 4 may include a silicon layer having N-type conductivity. The first material layer 4 may include doped polysilicon having N-type conductivity. The second material layer 9 may be disposed below the first material layer 4. The second material layer 9 may include at least one of a metal nitride, a metal-semiconductor compound, and a metal. The second material layer 9 may include at least one of Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi. For example, the second material layer 9 may include a 2-1 material layer 6 including at least one of a metal nitride and a metal-semiconductor compound, and a 2-2 material layer 8 disposed under the 2-1 material layer 6 and including a metal.

The first structure ST1 of the semiconductor device 1 may further include active patterns ACT. The active patterns ACT may be disposed on the bit lines BL. The active patterns ACT may be connected to the bit lines BL in a third direction D3. The third direction D3 may be perpendicular to the first direction D1 and the second direction D2. Each of the active patterns ACT may include a single-crystal silicon layer, an oxide semiconductor layer, or a two-dimensional material layer having semiconductor properties.

Each of the active patterns ACT may include a first region SD1, a second region SD2, and a channel region CH disposed between the first region SD1 and the second region SD2. The word line WL may face the channel regions CH of the active patterns ACT.

In each of the active patterns ACT, the first region SD1 may be a first source/drain region of the cell transistor cTR, the second region SD2 may be a second source/drain region of the cell transistor cTR, and the channel region CH may be a channel region of the cell transistor cTR.

The active patterns ACT may include a first active pattern ACT1 connected to the first bit line BL1 and a second active pattern ACT2 facing the second bit line BL2.

The conductive shield structure SLS may be disposed between the bit lines BL and between the first regions SD1 of the active patterns ACT. For example, the conductive shield structure SLS may include a portion disposed between the first bit line BL1 and the second bit line BL2, and between the first region SD1 of the first active pattern ACT1 and the first region SD1 of the second active pattern ACT2.

A portion of the conductive shield structure SLS may be disposed between the channel region CH of the first active pattern ACT1 and the second bit line BL2, and between the channel region CH of the second active pattern ACT2 and the first bit line BL1.

The conductive shield structure SLS may include at least one conductive material layer. For example, the conductive shield structure SLS may include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi.

In an example embodiment, the conductive shield structure SLS may be formed as a single layer.

In an example embodiment, the conductive shield structure SLS may include a plurality of layers or a plurality of patterns. For example, the conductive shield structure SLS may include a first shield pattern SL1 and a second shield pattern SL2 disposed between bit lines adjacent to each other among the bit lines BL and stacked in the third direction D3. For example, the conductive shield structure SLS may include the first shield pattern SL1 disposed between the first region SD1 of the first active pattern ACT1 and the first region SD1 of the second active pattern ACT2 and the second shield pattern SL2 disposed between the first bit line BL1 and the second bit line BL2.

The first shield pattern SL1 may include a first surface S1 in contact with the second shield pattern SL2 and a second surface S2 opposing the first surface S1 in the third direction D3.

The first shield pattern SL1 may include a first conductive material, and the second shield pattern SL2 may include a second conductive material different from the first conductive material. The first shield pattern SL1 may include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi, and the second shield pattern SL2 may include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi, differently from the material of the first shield pattern SL1. The dopant concentration in the doped polysilicon may be adjusted to control the work function. For example, the doped polysilicon may be first polysilicon having N-type conductivity having a lower work function by doping with an N-type dopant such as phosphorus (P) or arsenic (As), or second polysilicon having P-type conductivity having a higher work function by doping with a P-type dopant such as boron (B).

The first shield pattern SL1 may include a first material having a first work function, the second shield pattern SL2 may include a second material having a second work function. The second work function may be different from the first work function.

The second work function of the second material of the second shield pattern SL2 may be greater than the first work function of the first material of the first shield pattern SL1. For example, the first shield pattern SL1 may include doped polysilicon having a work function smaller than that of the second shield pattern SL2, and the second shield pattern SL2 may include a material (e.g., TiN, WN, TiSiN, Ru, or RuTiN) having a work function greater than that of the first shield pattern SL1. The first shield pattern SL1 may include polysilicon having P-type conductivity, and the second shield pattern SL2 may include polysilicon having N-type conductivity. According to an example embodiment, the first shield pattern SL1 may include polysilicon having N-type conductivity.

The conductive shield structure SLS may prevent electrical interference occurring between memory cells MC adjacent to each other among the memory cells (MC in FIG. 2), for example, characteristics of the memory cells MC from being degraded. For example, the first shield pattern SL1 may reduce capacitance coupling occurring between the second bit line BL2 and the channel region CH of the first active pattern ACT1, and may reduce capacitance coupling occurring between the first bit line BL1 and the channel region CH of the second active pattern ACT2. Accordingly, the first shield pattern SL1 of the conductive shield structure SLS may prevent characteristics of the operating memory cells MC from being degraded by other bit lines in the vicinity. The second shield pattern SL2 may reduce capacitance coupling occurring between bit lines BL adjacent to each other. Accordingly, the second shield pattern SL2 may reduce parasitic capacitance between bit lines BL adjacent to each other, such that a signal transmission speed of the bit lines BL may be prevented from being reduced by the bit lines BL adjacent to each other. Accordingly, the conductive shield structure SLS may improve performance of the semiconductor device 1.

Hereinafter, example embodiments of the semiconductor device 1 will be described. The various example embodiments described below and the example embodiments described above may be combined to form an example embodiment. Hereinafter, elements described above may be directly cited without a detailed description, or a description may not be provided. Also, elements described below which may be modified or replaced may be described with reference to the diagrams below, but elements which may be modified, replaced, or added may be combined with each other or with the elements described above to form a semiconductor device according to an example embodiment of the present disclosure. Also, in the case in which the previously described element includes multiple elements, the example in which the number of elements described above is one will be described.

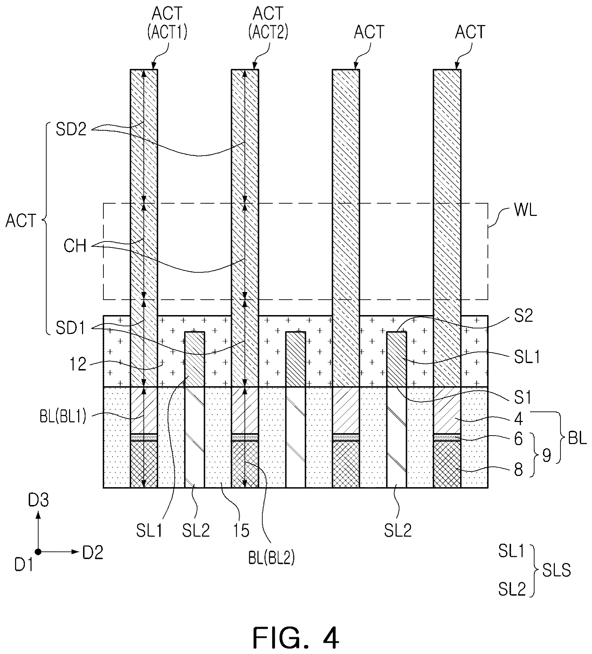

A semiconductor device according to an example embodiment will be described with reference to FIG. 4. FIG. 4 is a schematic diagram illustrating a cross-sectional view of a semiconductor device in the second direction D2 and the third direction D3 according to an example embodiment.

In an example embodiment, referring to FIG. 4, the semiconductor device 1 may further include a first dielectric layer 12 between the first regions SD1 of the active patterns ACT and a second dielectric layer 15 between the bit lines BL. For example, the first dielectric layer 12 may be disposed between the conductive shield structure SLS and the first region SD1 of the first active pattern ACT1, and between the conductive shield structure SLS and the first region SD1 of the second active pattern ACT2. The first dielectric layer 12 and the second dielectric layer 15 may be disposed between the conductive shield structure SLS and the first bit line BL1, and between the conductive shield structure SLS and the second bit line BL2. The first dielectric layer 12 may cover side surfaces of the first shield pattern SL1 and the second surface S2 of the first shield pattern SL1. The second dielectric layer 15 may cover side surfaces of the second shield pattern SL2.

The first dielectric layer 12 and the second dielectric layer 15 may have different dielectric constants.

The dielectric constant of the first dielectric layer 12 may be greater than the dielectric constant of the second dielectric layer 15. For example, when the second dielectric layer 15 includes a low-κ dielectric, the first dielectric layer 12 may include silicon oxide or silicon nitride having a dielectric constant higher than that of the low-κ dielectric. When the second dielectric layer 15 includes silicon oxide, the first dielectric layer 12 may include silicon nitride.

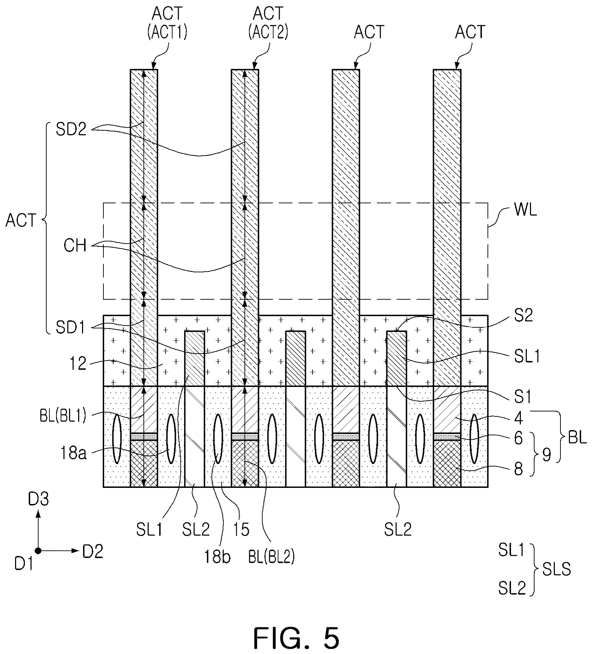

A semiconductor device according to an example embodiment will be described with reference to FIG. 5. FIG. 5 is a schematic diagram illustrating a cross-sectional view of a semiconductor device in the second direction D2 and the third direction D3 according to an example embodiment.

In an example embodiment, referring to FIG. 5, the semiconductor device 1 may further include air gaps 18a and 18b in the second dielectric layer 15 described with reference to FIG. 4. For example, the air gaps 18a and 18b may include a first air gap 18a between the conductive shield structure SLS and the first bit line BL1 and a second air gap 18b between the conductive shield structure SLS and the second bit line BL2.

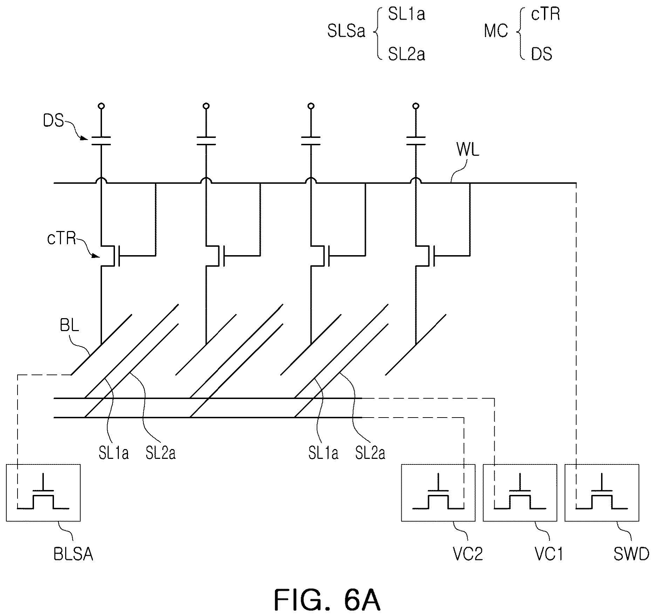

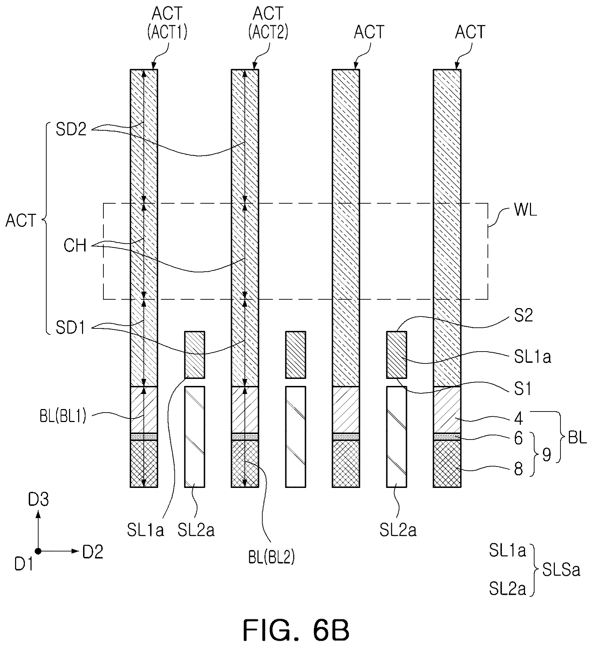

A semiconductor device according to an example embodiment will be described with reference to FIGS. 6A and 6B. In FIGS. 6A and 6B, FIG. 6A is a circuit diagram including a semiconductor device according to an example embodiment, and FIG. 6B is a schematic diagram illustrating a cross-sectional view of a semiconductor device in the second direction D2 and the third direction D3 according to an example embodiment.

Referring to FIGS. 6A and 6B, the first shield pattern SL1 and the second shield pattern SL2 described above may be replaced with the first shield pattern SL1a and the second shield pattern SL2a spaced apart from each other in the third direction D3. Accordingly, the conductive shield structure SLS described above may be replaced with the conductive shield structure SLSa including the first shield pattern SL1a and the second shield pattern SL2a spaced apart from each other in the third direction D3.

The voltage control circuit (VC in FIG. 2) described above may include a circuit VC1 electrically connected to the first shield pattern SL1a and applying a first voltage to the first shield pattern SL1a, and a second circuit VC2 electrically connected to the second shield pattern SL2a and applying a second voltage different from the first voltage to the second shield pattern SL2a. The first voltage applied to the first shield pattern SL1a by the first circuit VC1 may be higher than the second voltage applied to the second shield pattern SL2a by the second circuit VC2. For example, the second voltage may be a positive voltage, and the first voltage may be a positive voltage higher than the second voltage.

Hereinafter, the first region SD1 may be referred to as first source/drain region, and the second region SD2 is referred to as second source/drain region.

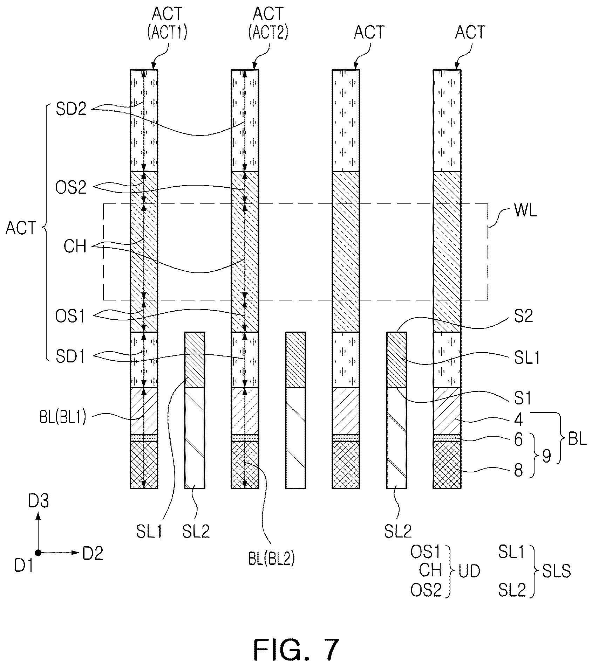

A semiconductor device according to an example embodiment will be described with reference to FIG. 7. FIG. 7 is a schematic diagram illustrating a cross-sectional view of a semiconductor device in the second direction D2 and the third direction D3 according to an example embodiment.

Referring to FIG. 7, each of the active patterns ACT may further include at least one of a first offset region OS1 between the channel region CH and the first source/drain region SD1 and a second offset region OS2 between the channel region CH and the second source/drain region SD2. For example, each of the active patterns ACT may include the first offset region OS1 and the second offset region OS2.

The word line WL may face the channel region CH and may not face the first offset region OS1 and the second offset region OS2.

A length in the third direction D3 of the first offset region OS1 may be substantially the same as a length in the third direction D3 of the second offset region OS2. In one or more aspects, the term "substantially the same" may indicate "being the same" or being within an industry-accepted tolerance, due to a process error or a measurement error recognizable by one of ordinary skill in the art provide, for the corresponding term and/or relativity between items, such as a tolerance of ± 1%, ± 5%, or ± 10% of the actual value stated, and other suitable tolerances.

An upper surface of the conductive shield structure SLS, that is, a second surface S2 of the first shield pattern SL1, may be disposed at substantially the same level as the region between the first source/drain region SD1 and the first offset region OS1.

In an example embodiment, the second surface S2 of the first shield pattern SL1 may be defined as an upper surface.

The first and second source/drain regions SD1 and SD2 may have N-type conductivity.

In each of the active patterns ACT, the first offset region OS1, the channel region CH, and the second offset region OS2 may be defined as an intermediate region UD. The intermediate region UD may be an undoped region. For example, the first offset region OS1, the channel region CH, and the second offset region OS2 may be undoped semiconductor regions.

The first offset region OS1 and the second offset region OS2 may improve performance of the semiconductor device 1.

In an example, the first offset region OS1 and the second offset region OS2 may prevent electrical interference occurring between memory cells MC adjacent to each other among the memory cells (MC in FIG. 2), for example, characteristics of memory cells MC by capacitance coupling.

In an example, the first offset region OS1 and the second offset region OS2 may prevent characteristics of the memory cells MC from being degraded by gate-induced-drain leakage (GIDL).

In an example, the first offset region OS1 may reduce electrical interference between the channel region CH of the first active pattern ACT1 and the first source/drain region SD1 of the second active pattern ACT2, and between the channel region CH of the second active pattern ACT2 and the first source/drain region SD1 of the first active pattern ACT1.

In an example, the second offset region OS2 may reduce electrical interference between the channel region CH of the first active pattern ACT1 and the second source/drain region SD2 of the second active pattern ACT2, and between the channel region CH of the second active pattern ACT2 and the second source/drain region SD2 of the first active pattern ACT1.

The first offset region OS1 and the conductive shield structure SLS may prevent characteristics of the operating memory cells MC from being degraded by other bit lines in the vicinity.

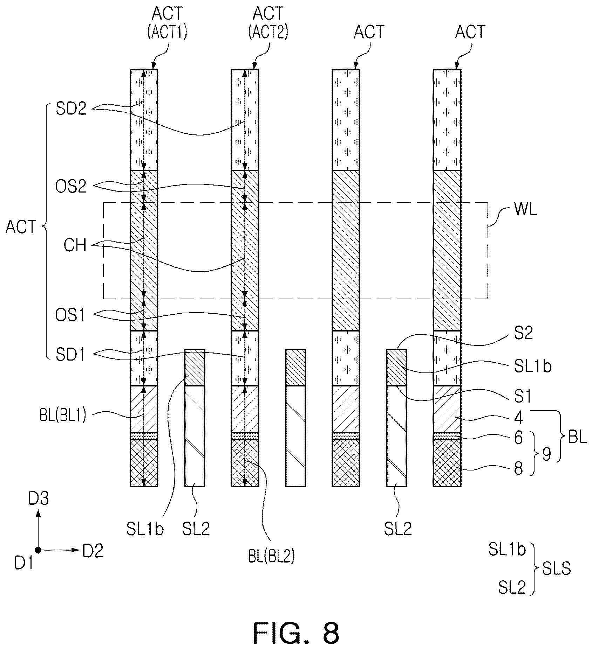

A semiconductor device according to an example embodiment will be described with reference to FIG. 8. FIG. 8 is a schematic diagram illustrating a cross-sectional view of a semiconductor device in the second direction D2 and the third direction D3 according to an example embodiment.

Referring to FIG. 8, the first shield pattern SL1 in FIG. 7 may be replaced with the first shield pattern SL1b illustrated in FIG. 8. For example, the first shield pattern SL1b may have an upper surface S2 disposed at a level lower than the first offset region OS1.

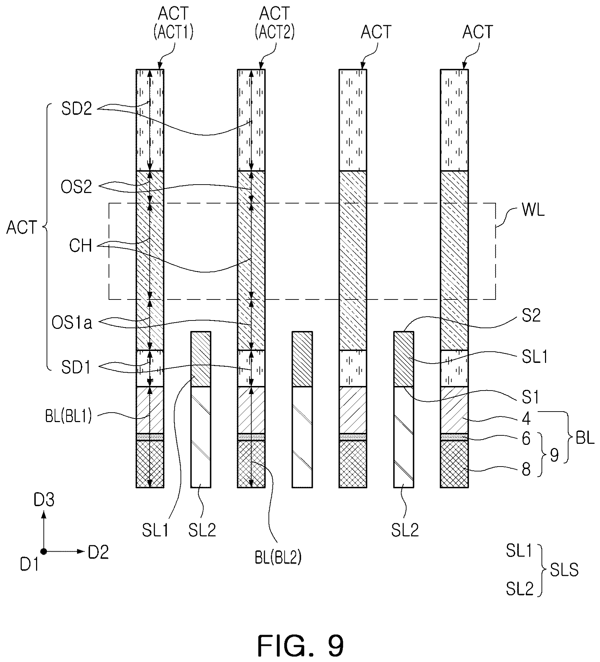

A semiconductor device according to an example embodiment will be described with reference to FIG. 9. FIG. 9 is a schematic diagram illustrating a cross-sectional view of a semiconductor device in the second direction D2 and the third direction D3 according to an example embodiment.

Referring to FIG. 9, the first offset region OS1 in FIG. 7 may be replaced with the first offset region OSla illustrated in FIG. 9. The first offset region OS1a may have a lower surface disposed at a level lower than the upper surface S2 of the first shield pattern SL1. Accordingly, an upper region of the first shield pattern SL1 may be disposed between the first offset region OS1a of the first active pattern ACT1 and the first offset region OS1a of the second active pattern ACT2.

The length in the third direction D3 of the first offset region OS1a may be different from the length in the third direction D3 of the second offset region OS2.

The length in the third direction D3 of the first offset region OS1a may be greater than the length in the third direction D3 of the second offset region OS2.

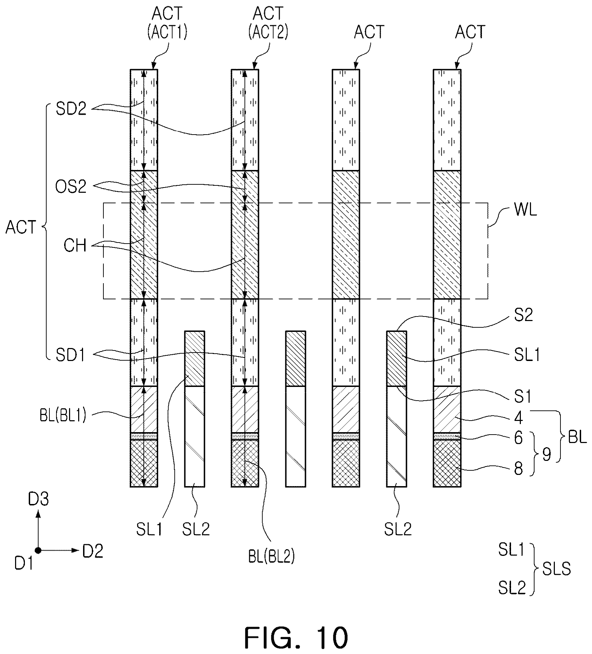

A semiconductor device according to an example embodiment will be described with reference to FIG. 10. FIG. 10 is a schematic diagram illustrating a cross-sectional view of a semiconductor device in the second direction D2 and the third direction D3 according to an example embodiment.

Referring to FIG. 10, among the first offset region OS1 and the second offset region OS2 described with reference to FIG. 7, the first offset region OS1 may not be provided. Accordingly, each of the active patterns ACT may include the first source/drain region SD1, the channel region CH, the second offset region OS2, and the second source/drain region SD2.

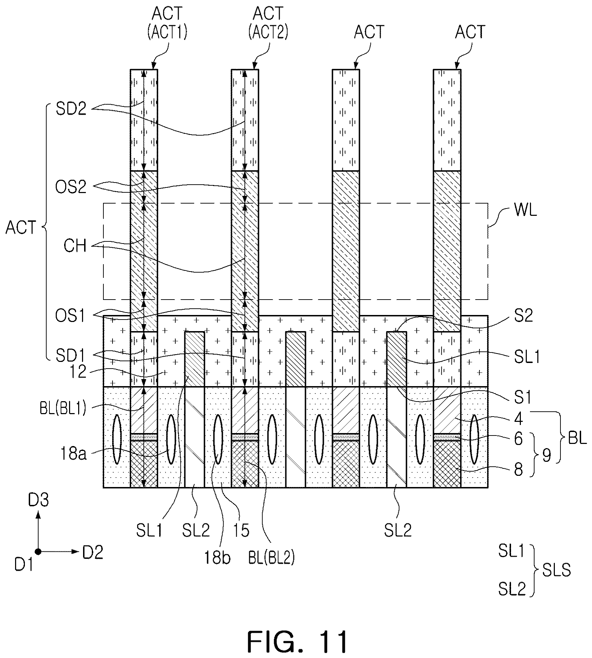

A semiconductor device according to an example embodiment will be described with reference to FIG. 11. FIG. 11 is a schematic diagram illustrating a cross-sectional view of a semiconductor device in the second direction D2 and the third direction D3 according to an example embodiment.

Referring to FIG. 11, the first dielectric layer 12 may be disposed between the first source/drain regions SD1 of the active patterns ACT and the second dielectric layer 15 may be disposed between the bit lines BL as described with reference to FIG. 4. A portion of the first dielectric layer 12 may be disposed between the first offset regions OS1 of the active patterns ACT. The air gaps 18a and 18b may be disposed in the second dielectric layer 15 as described with reference to FIG. 5.

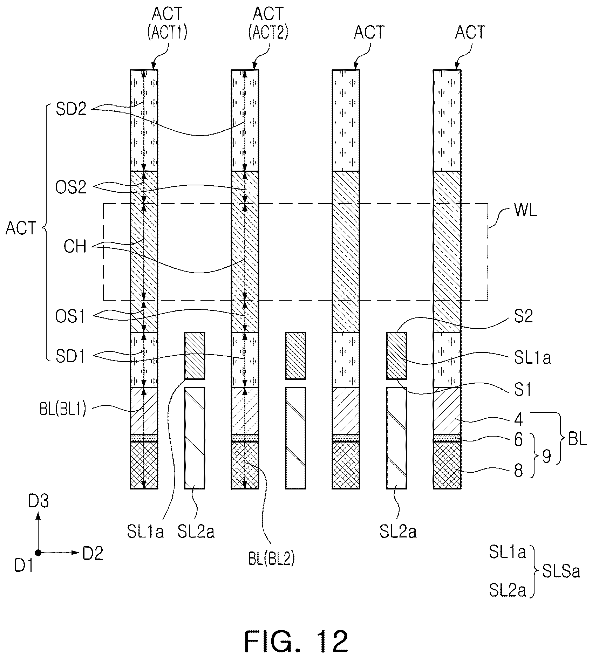

A semiconductor device according to an example embodiment will be described with reference to FIG. 12. FIG. 12 is a schematic diagram illustrating a cross-sectional view of a semiconductor device in the second direction D2 and the third direction D3 according to an example embodiment.

Referring to FIG. 12, the first shield pattern SL1 and the second shield pattern SL2 in contact with each other in the example embodiments in FIGS. 7 to 10 may be replaced with the first shield pattern SL1a and the second shield pattern SL2a spaced apart from each other in the third direction D3 as in FIGS. 6A and 6B. Accordingly, the conductive shield structure SLS described above may be replaced with the conductive shield structure SLSa including the first shield pattern SL1a and the second shield pattern SL2a.

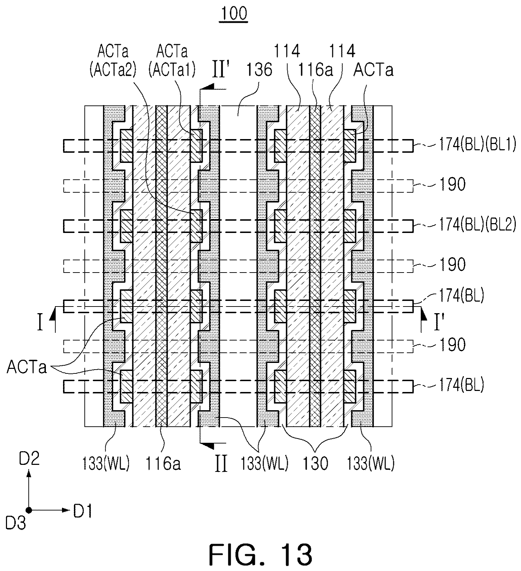

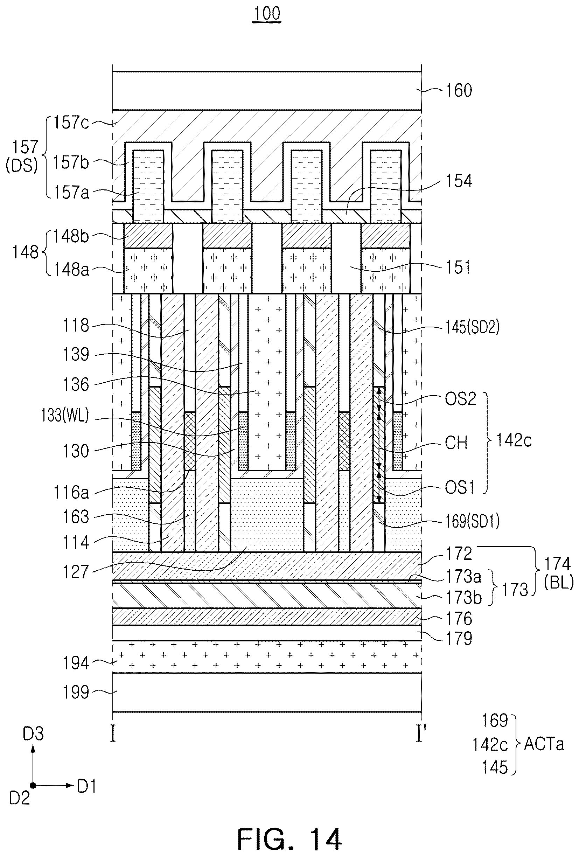

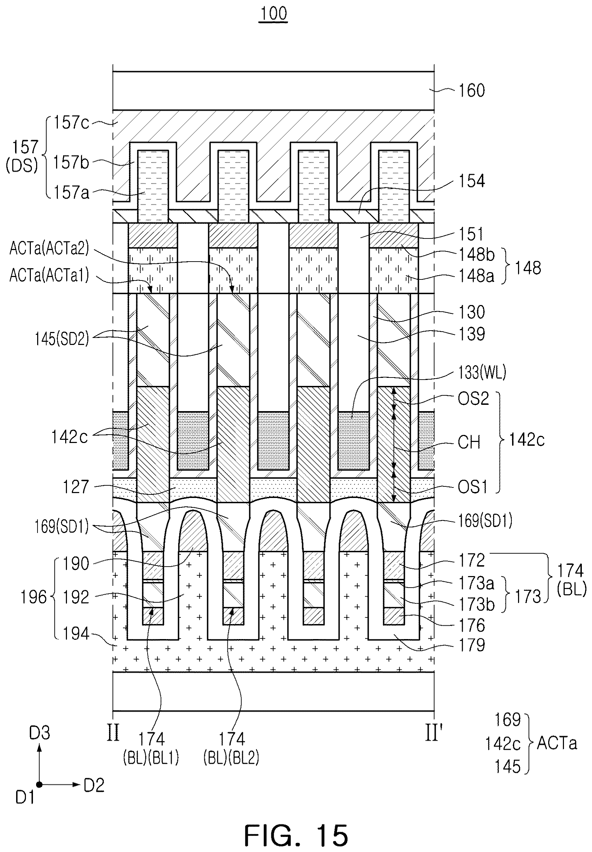

In the description below, a semiconductor device according to an example embodiment will be described with reference to FIGS. 13, 14, and 15. The elements described with reference to FIGS. 13, 14, and 15 may be a portion of the first structure ST1 in FIG. 1 described above. In FIGS. 13, 14, and 15, FIG. 13 is a plan diagram illustrating a semiconductor device according to an example embodiment, FIG. 14 is a cross-sectional diagram illustrating a region taken along line I-I' in FIG. 13, and FIG. 15 is a cross-sectional diagram illustrating a region taken along line **II-II'** in FIG. 13.

Referring to FIGS. 13, 14, and 15, a semiconductor device 100 in the example embodiment may include a lower structure 199, conductive lines 174, active patterns ACTa, cell gate electrodes 133, back gate electrodes 116a, a conductive shield structure 196, and a data storage structure 157.

The conductive lines 174 may be disposed on the lower structure 199. The conductive lines 174 may be the bit lines BL described in the example embodiments above.

Hereinafter, the conductive lines 174 may be referred to as bit lines BL.

As described above, each of the bit lines BL may extend in the first direction D1. The bit lines BL may include a first bit line BL1 and a second bit line BL2 adjacent to each other in the second direction D2.

Each of the first bit line BL1 and the second bit line BL2 may include a first material layer 172 and a second material layer 173 vertically aligned. The first material layer 172 may be the first material layer (4 in FIG. 3) described above, and the second material layer 173 may be the second material layer (9 in FIG. 3) described above. The second material layer 173 may include a 2-1 material layer 173a including at least one of a metal nitride and a metal-semiconductor compound, and a 2-2 material layer 173b disposed under the 2-1 material layer 173a and including a metal.

The semiconductor device 100 may further include insulating bit line capping patterns 176 disposed below the bit lines BL and aligned vertically with the bit lines BL.

The cell gate electrodes 133 may be the gate electrodes of the cell transistor (cTR in FIG. 2) described above. The cell gate electrodes 133 may be the word lines WL described above.

Hereinafter, the cell gate electrodes 133 will be referred to as word lines WL.

The word lines WL may be disposed at a level higher than the bit lines BL on the lower structure 199. Each of the word lines WL may extend in the second direction D2.

At least a portion of each of the back gate electrodes 116a may be disposed at the same level as at least a portion of each of the word lines WL. Each of the back gate electrodes 116a may extend in the second direction D2.

Among the back gate electrodes 116a parallel to each other, a pair of word lines WL adjacent to each other may be disposed between a pair of back gate electrodes 116a.

The active patterns ACTa may be disposed between the back gate electrodes 116a and the word lines WL. The active patterns ACTa may be disposed on the bit lines BL. The active patterns ACTa may be arranged in the first direction D1 and the second direction D2.

The active patterns ACTa may be connected to the bit lines BL in the third direction D3. Each of the active patterns ACTa may include a single crystal silicon layer, an oxide semiconductor layer, or a two-dimensional material layer having semiconductor properties.

Each of the active patterns ACTa may include a first region 169, a second region 145, and an intermediate region 142c disposed between the first region 169 and the second region 145. In each of the active patterns ACTa, the first region 169 may be the first source/drain region SD1 of the cell transistor (cTR in FIG. 2) described above, the second region 145 may be the second source/drain region SD2 of the cell transistor (cTR in FIG. 2) described above, and the intermediate region 142c may include the channel region CH of the cell transistor (cTR in FIG. 2) described above.

The intermediate region 142c may further include at least one of the first offset region OS1 and the second offset region OS2 described with reference to FIG. 7 above. The intermediate region 142c may be the intermediate region (UD in FIG. 7) which may be an undoped region as described with reference to FIG. 7. Accordingly, each of the active patterns ACTa may include the first source/drain region SD1, the first offset region OS1, the channel region CH, the second offset region OS2, and the second source/drain region SD2, arranged in order in the third direction D3 away from the bit lines BL.

In each of the active patterns ACTa, the length in the third direction D3 of the second source/drain region SD2 may be greater than the length in the third direction D3 of the first source/drain region SD1.

A width in the second direction D2 of each of the channel regions CH of the active patterns ACTa may be greater than the width in the second direction D2 of each of the bit lines BL.

In each of the active patterns ACTa, the width of the first source/drain region SD1 may increase from a region in contact with the bit line BL in a direction toward the channel region CH. For example, in each of the active patterns ACTa, the first source/drain region SD1 may have a first width substantially the same as that of the bit line BL in a region in contact with the bit line BL, and may have a second width the same as a width of the channel region CH in a region adjacent to the channel region CH. Here, the second width may be greater than the first width.

A minimum width in the second direction D2 of the channel region CH of the active pattern ACTa may be greater than the minimum width in the second direction D2 of the first source/drain region SD1 of the active pattern ACTa.

The active patterns ACTa may include a first active pattern ACTa1 connected to the first bit line BL1 and a second active pattern ACTa2 facing the second bit line BL2.

The conductive shield structure 196 may be disposed between the bit lines BL, and between the first source/drain regions SD1 of the active patterns ACTa. For example, the conductive shield structure 196 may include a portion disposed between the first bit line BL1 and the second bit line BL2, and between the first source/drain region SD1 of the first active pattern ACTa1 and the first source/drain region SD1 of the second active pattern ACTa2.

The conductive shield structure 196 may extend from the portion disposed between the bit lines BL to a region between the bit line capping patterns 176 and the lower structure 199.

A portion of the conductive shield structure 196 may be disposed between the channel region CH of the first active pattern ACTa1 and the second bit line BL2, and between the channel region CH of the second active pattern ACTa2 and the first bit line BL1.

The conductive shield structure 196 may include at least one conductive material. For example, the conductive shield structure 196 may be the conductive shield structure SLS described above.

In an example embodiment, the conductive shield structure 196 may include a single layer.

In an example embodiment, the conductive shield structure 196 may include a plurality of layers or a plurality of patterns. For example, the conductive shield structure 196 may include a first shield pattern 190 and a second shield pattern 192 disposed between bit lines adjacent to each other among the bit lines BL and stacked in the third direction D3. For example, the conductive shield structure 196 may include the first shield pattern 190 disposed between the first source/drain region SD1 of the first active pattern ACTa1 and the first source/drain region SD1 of the second active pattern ACTa2 and the second shield pattern 192 disposed between the first bit line BL1 and the second bit line BL2.

The conductive shield structure 196 may further include a plate portion 194 extending from the second shield pattern 192 and extending below the bit line capping patterns 176. The plate portion 194 may overlap the bit lines BL in the third direction D3.

The first shield pattern 190 may have a first surface in contact with the second shield pattern 192 and a second surface opposing the first surface in the third direction D3.

The first shield pattern 190 may be substantially the same as the first shield pattern SL1 described above, and the second shield pattern 192 may be substantially the same as the second shield pattern SL2 described above. For example, the first shield pattern 190 may be formed of the same material as that of the first shield pattern SL1 described above, and the second shield pattern 192 may be formed of the same material as that of the second shield pattern SL2 described above. A work function of the first shield pattern 190 may be different from a work function of the second shield pattern 192. The work function of the second shield pattern 192 may be greater than the work function of the first shield pattern 190.

The semiconductor device 100 may further include a dielectric layer 179 disposed between the bit lines BL and the conductive shield structure 196.

The dielectric layer 179 may include a portion disposed between the second shield patterns 192 and the bit lines BL, a portion disposed between the first shield patterns 190 and the active patterns ACTa, a portion covering upper surfaces of the first shield patterns 190, and a portion disposed between the bit line capping patterns 176 and the conductive shield structure 196.

The semiconductor device 100 may further include insulating patterns 127 disposed between the active patterns ACTa at a level lower than the word lines WL and covering an upper surface of the dielectric layer 179.

The semiconductor device 100 may further include insulating gate capping patterns 139 disposed on upper surfaces of the word lines WL.

The semiconductor device 100 may further include insulating isolation patterns 136 disposed between word lines WL adjacent to each other and extending between the gate capping patterns 139.

The semiconductor device 100 may further include insulating first back gate capping patterns 118 disposed on the back gate electrodes 116a and second back gate capping patterns 163 disposed below the back gate electrodes 116a.

The semiconductor device 100 may further include a back gate dielectric layer 114 disposed between the back gate electrodes 116a and the active patterns ACTa. The back gate dielectric layer 114 may extend between the first back gate capping patterns 118 and the active patterns ACTa, and between the second back gate capping patterns 163 and the active patterns ACTa.

The semiconductor device 100 may further include insulating patterns 127 disposed below the word lines WL and disposed between the active patterns ACTa.

The semiconductor device 100 may further include a cell gate dielectric layer 130 disposed between the word lines WL and the active patterns ACTa. The cell gate dielectric layer 130 may be the gate dielectric layer of the cell transistor (cTR in FIG. 2) described above. The cell gate dielectric layer 130 may extend from a portion disposed between the word lines WL and the active patterns ACTa to between the gate capping patterns 139 and the active patterns ACTa, between the insulating patterns 127 and the word lines WL, and between the insulating patterns 127 and the insulating isolation patterns 136.

The semiconductor device 100 may further include contact structures 148 and insulating structure 151. The contact structures 148 may be disposed on the active patterns ACTa. The contact structures 148 may be electrically connected to the active patterns ACTa. For example, the contact structures 148 may be electrically connected to the second source/drain regions SD2 of the active patterns ACTa. Each of the contact structures 148 may include a first material layer 148a and a second material layer 148b on the first material layer 148a. The first material layer 148a may include a material such as doped silicon. The second material layer 148b may include one of a metal, a metal nitride, and a metal-semiconductor compound. The insulating structure 151 may surround side surfaces of the contact structures 148.

The semiconductor device 100 may further include an insulating etching stop layer 154 disposed on the contact structures 148 and the insulating structure 151.

The data storage structure 157 may include first electrodes 157a penetrating the insulating etching stop layer 154, connected to the contact structures 148, and extending upwardly, a dielectric layer 157b covering the first electrodes 157a and the etching stop layer 154, and a second electrode 157c covering the dielectric layer 157b. The data storage structure 157 may be the data storage structure DS of the memory cells (MC in FIG. 2) described above. The semiconductor device 100 may further include an upper structure 160 on the data storage structure 157.

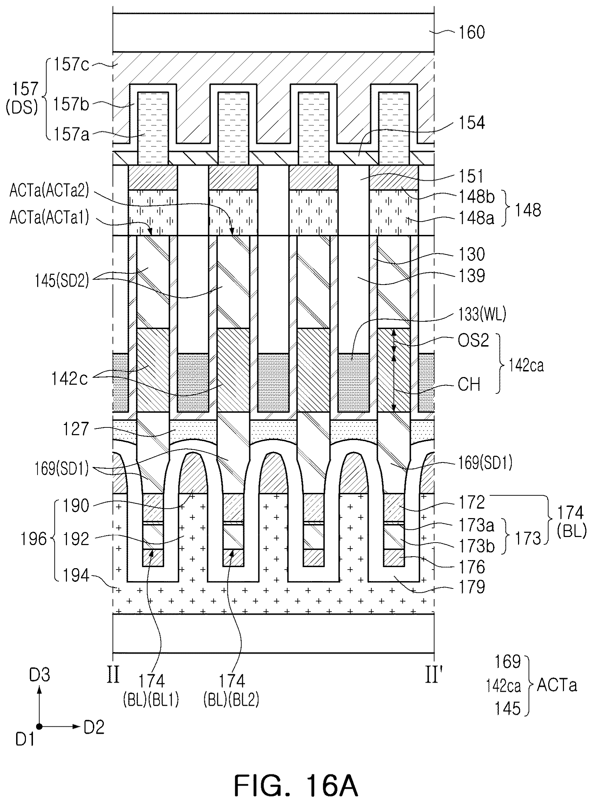

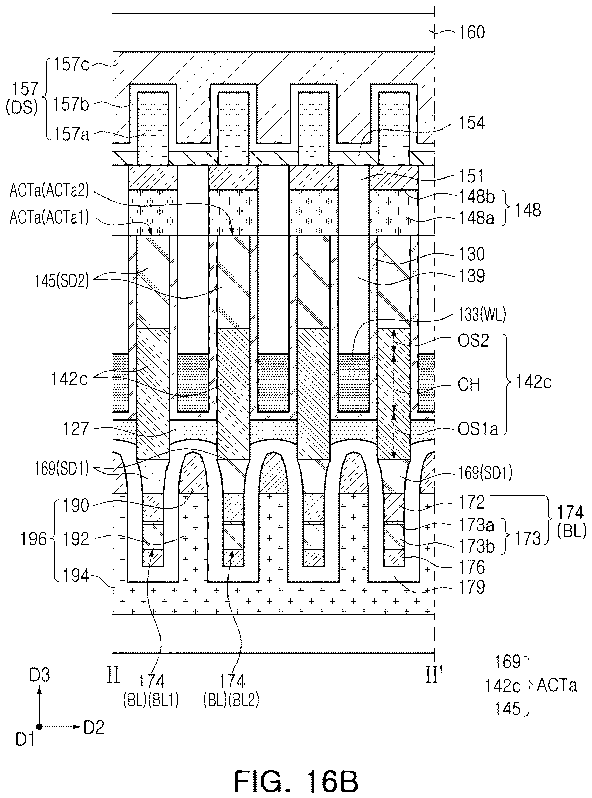

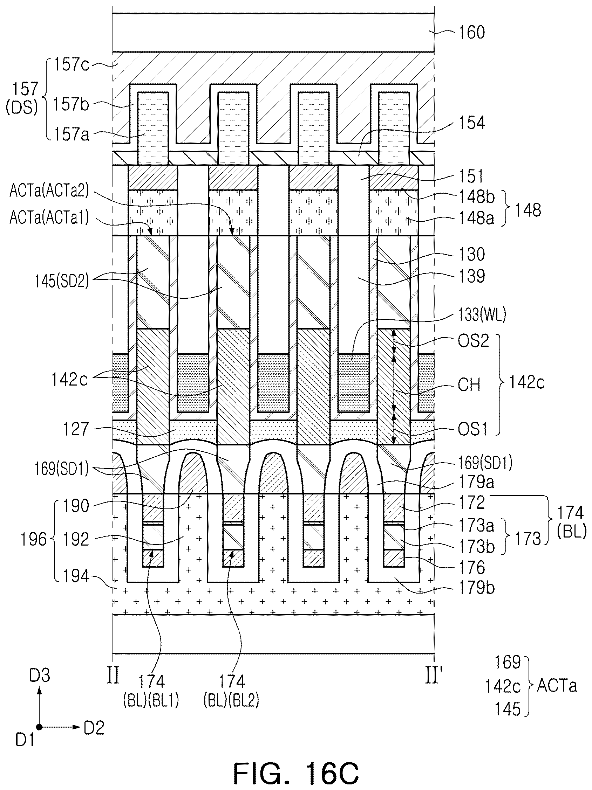

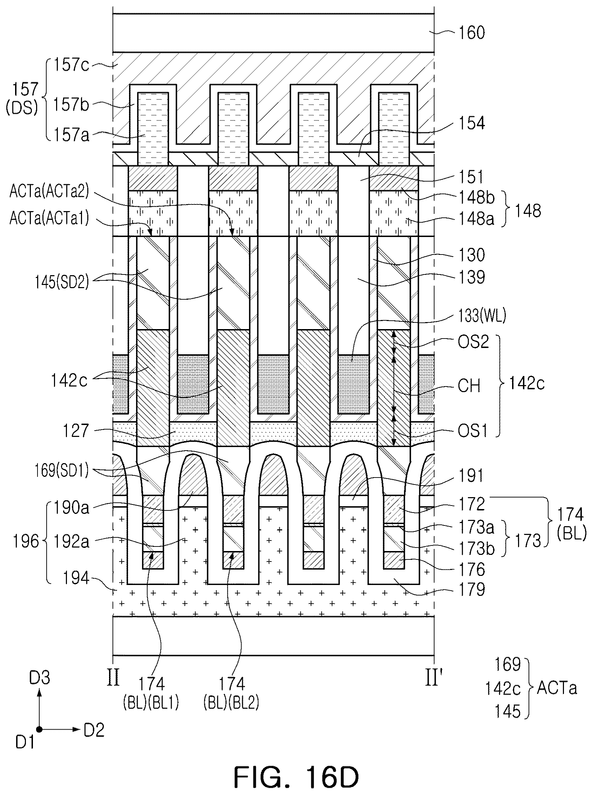

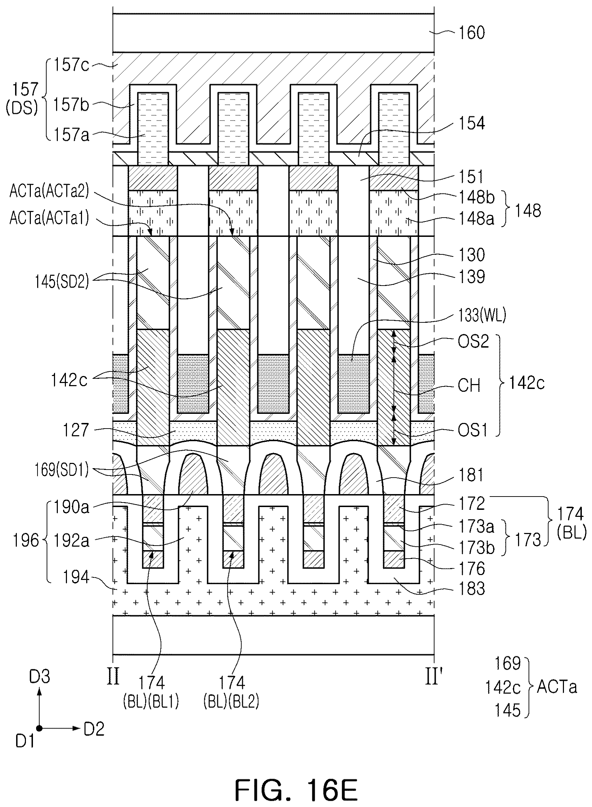

The semiconductor device 100 described with reference to FIGS. 13, 14, and 15 will be described with reference to FIGS. 16A, 16B, 16C, 16D, and 16E.

The semiconductor device 100 described with reference to FIGS. 13, 14, and 15 will be described with reference to FIG. 16A. FIG. 16A is a cross-sectional diagram illustrating a region taken along line II-II' in FIG. 13.

Referring to FIG. 16A, the first offset region (OS1 in FIGS. 14 and 15) described with reference to FIGS. 14 and 15 may not be provided. Accordingly, the intermediate region 142c described with reference to FIGS. 14 and 15 may be replaced with an intermediate region 142ca including the channel region CH and the second offset region OS2.

The semiconductor device 100 described with reference to FIGS. 13, 14, and 15 will be described with reference to FIG. 16B. FIG. 16B is a cross-sectional diagram illustrating a region taken along line II-II' in FIG. 13.

Referring to FIG. 16B, the first offset region OS1 in FIGS. 14 and 15 may be replaced with a first offset region OS1a having an increased length. A length in the third direction D3 of the first offset region OS1a may be greater than a length in the third direction D3 of the second offset region OS2. A portion of the first shield pattern 190 may be disposed between the first offset regions OS1a adjacent to each other in the second direction D2.

The semiconductor device 100 described with reference to FIGS. 13, 14, and 15 will be described with reference to FIG. 16C. FIG. 16C is a cross-sectional diagram illustrating a region taken along line II-II' in FIG. 13.

Referring to FIG. 16C, the dielectric layer 179 in the liner shape in FIGS. 14 and 15 continuously extending may be replaced with a first dielectric layer 179a and a second dielectric layer 179b including different materials.

The first dielectric layer 179a may be disposed between the first source/drain regions SD1 adjacent to each other in the second direction D2, and may cover the side surface and the upper surface of the first shield pattern 190. The second dielectric layer 179b may be disposed below the first dielectric layer 179a, and may extend to cover side surfaces of the second shield pattern 192 between the bit lines BL and to cover a lower surface of the bit line capping pattern 176. The first dielectric layer 179a may be formed of the same material as that of the first dielectric layer (12 in FIG. 4) described above, and the second dielectric layer 179b may be formed of the same material as that of the second dielectric layer (15 in FIG. 4) described above.

The semiconductor device 100 described with reference to FIGS. 13, 14, and 15 will be described with reference to FIG. 16D. FIG. 16D is a cross-sectional diagram illustrating a region taken along line II-II' in FIG. 13.

Referring to FIG. 16D, the first shield pattern 190 and the second shield pattern 192 in contact with each other, described with reference to FIGS. 14 and 15, may be replaced with the first shield pattern 190a and the second shield pattern 192a spaced apart from each other in the third direction D3. An isolation dielectric layer 191 to electrically isolate the first shield pattern 190a and the second shield pattern 192a from each other may be disposed between the first shield pattern 190a and the second shield pattern 192a.

The first shield pattern 190a may correspond to the first shield pattern SL1a described with reference to FIGS. 6A and 6B, and the second shield pattern 192a may correspond to the second shield pattern SL2a described with reference to FIGS. 6A and 6B.

The semiconductor device 100 described with reference to FIGS. 13, 14, and 15 will be described with reference to FIG. 16E. FIG. 16E is a cross-sectional diagram illustrating a region taken along line II-II' in FIG. 13.

Referring to FIG. 16E, the first shield pattern 190 and the second shield pattern 192 described with reference to FIGS. 14 and 15 may be replaced with the first shield pattern 190a and the second shield pattern 192a illustrated in FIG. 16E. The dielectric layer 179 described with reference to FIGS. 14 and 15 may be replaced with a first dielectric layer 181 and a second dielectric layer 183.

The first dielectric layer 181 may be disposed between the first source/drain regions SD1 adjacent to each other in the second direction D2 and may cover a side surface and an upper surface of the first shield pattern 190a. The second dielectric layer 183 may be disposed between the first shield pattern 190a and the second shield pattern 192a and may cover side surfaces of the second shield pattern 192a between the bit lines BL and may extend to cover a lower surface of the bit line capping pattern 176. The first dielectric layer 181 may be formed of the same material as that of the first dielectric layer (12 in FIG. 4) described above, and the second dielectric layer 183 may be formed of the same material as that of the second dielectric layer (15 in FIG. 4) described above.

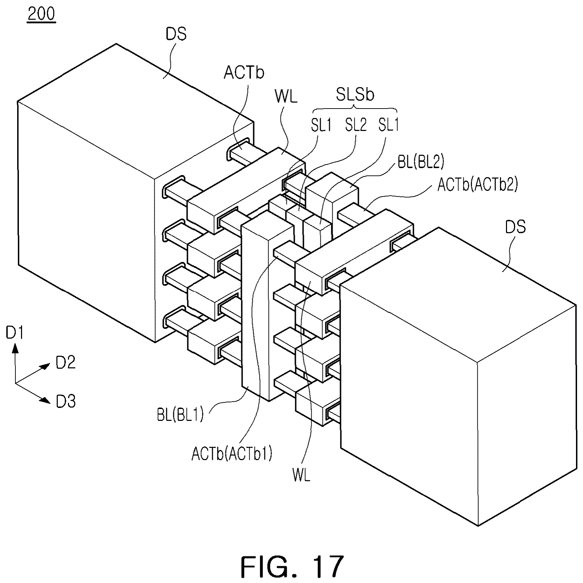

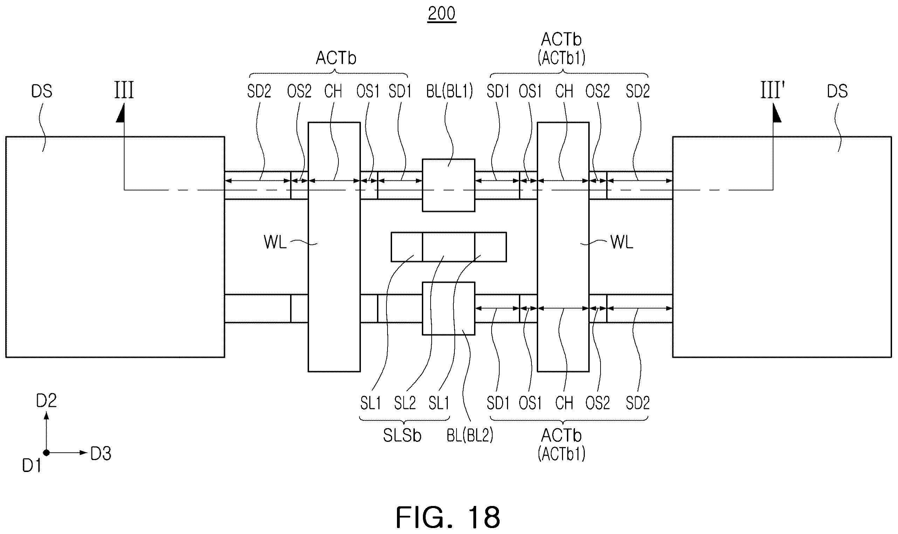

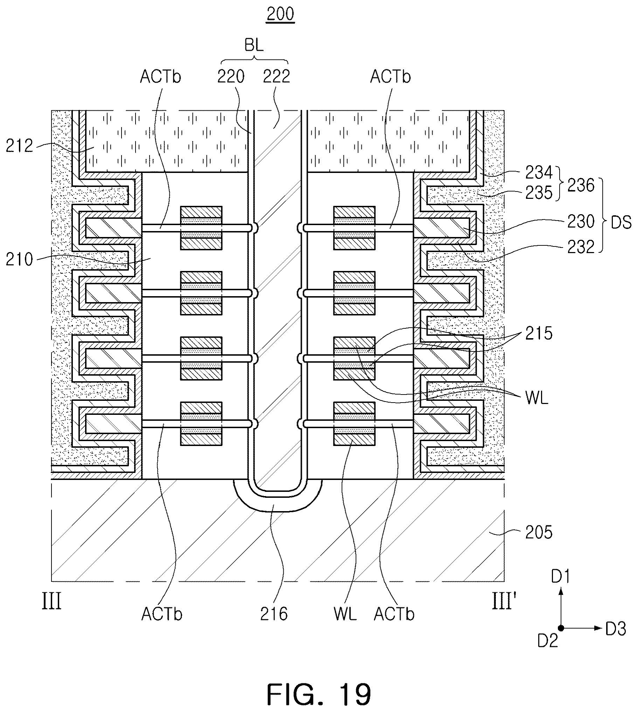

In the description below, a semiconductor device according to an example embodiment will be described with reference to FIGS. 17, 18 and 19. The elements described with reference to FIGS. 17, 18 and 19 may be a portion of the first structure ST1 in FIG. 1 described above. In FIGS. 17, 18 and 19, FIG. 17 is a perspective diagram illustrating a semiconductor device according to an example embodiment, FIG. 18 is a plan diagram illustrating a semiconductor device according to an example embodiment, and FIG. 19 is a cross-sectional diagram illustrating a region taken along line III-III' in FIG. 18.

Referring to FIGS. 17, 18 and 19, a semiconductor device 200 in the example embodiment may include a base 205, active patterns ACTb, bit lines BL, word lines WL, a conductive shield structure SLSb, and a data storage structure DS.

The base 205 may be a semiconductor substrate, but an example embodiment thereof is not limited thereto. For example, the base 205 may be an insulating substrate.

The active patterns ACTb may be disposed on the base 205. The active patterns ACTb may be formed of the same material as that of the active patterns ACT and ACTa described above. Each of the active patterns ACTb may have a bar shape extending in a third direction D3. The third direction D3 may be parallel to an upper surface of the base 205. Each of the active patterns ACTb may include a first source/drain region SD1 and a second source/drain region SD2 spaced apart from each other in the third direction D3, and a channel region CH between the first and second source/drain regions SD1 and SD2.

Each of the active patterns ACTb may further include at least one of the first offset region OS1 and the second offset region OS2 described in the above FIG. 7. Each of the active patterns ACTb may include the first source/drain region SD1, the first offset region OS1, the channel region CH, the second offset region OS2, and the second source/drain region SD2, arranged in order in the third direction D3 away from the bit lines BL. The word lines WL may overlap the channel regions CH vertically. The word lines WL may be stacked and spaced apart from each other in the first direction D1. Each of the word lines WL may surround a corresponding channel region CH among the channel regions CH and may extend in the second direction D2 perpendicular to the third direction D3.

The semiconductor device 200 may further include cell gate dielectric layers 215 between the word lines WL and the channel regions CH. In example embodiments, each of the data storage structures DS may include a first electrode 230 connected to a corresponding second source/drain region SD2 among the second source/drain regions SD2, a second electrode 236 covering the first electrode 230, and a dielectric layer 232 between the first electrode 230 and the second electrode 236. The second electrodes 236 may be plate electrodes.

In each of the data storage structures DS, the first electrode 230 may have a columnar shape extending in the third direction D3, and the second electrode 236 may include a first electrode material layer 234 in contact with the dielectric layer 232 and a second electrode material layer 235 in contact with the first electrode material layer 234. In an example embodiment, the first electrode 230 is not limited to a columnar shape. For example, the first electrode 230 may have a cylindrical shape.

The semiconductor device 200 may include an insulating structure 210 disposed on the base 205 and covering the active patterns ACTb and the word lines WL.

The semiconductor device 200 may further include a capping insulating layer 212 disposed on the insulating structure 210 and an insulating layer 216 between the bit lines BL and the base 205. The second electrode 236 may extend upwardly and may penetrate the capping insulating layer 212.

Each of the bit lines BL may extend in the first direction D1. For example, each of the bit lines BL may have a columnar shape extending in the first direction D1. On the plane, the bit lines BL may be arranged in the third direction D3 and the second direction D2 perpendicular to each other. The bit lines BL may be connected to the first source/drain regions SD1 of the active patterns ACTb. The bit lines BL may extend upwardly and may penetrate the capping insulating layer 212.

Each of the bit lines BL may include a pillar pattern 222 and a conductive liner 220 covering a side surface and a lower surface of the pillar pattern 222. The conductive liner 220 may include at least one of doped polysilicon, a metal-semiconductor compound, and a metal nitride. For example, the conductive liner 220 may include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi, and the pillar pattern 222 may include a material different from the material of the conductive liner 220 and may include at least one of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, or CoSi.

The bit lines BL may be disposed between the data storage structures DS adjacent to each other in the third direction D3, and the active patterns ACTb may be disposed between the bit lines BL and the data storage structures DS.

The conductive shield structure SLSb may include a first shield pattern SL1 disposed between the first source/drain regions SD1 of the active patterns ACTb adjacent to each other in the second direction D2, and a second shield pattern SL2 disposed between the bit lines BL adjacent to each other in the second direction D2. The conductive shield structure SLSb may have a columnar shape extending in the first direction D1. The first shield pattern SL1 may have a columnar shape extending in the first direction D1. The second shield pattern SL2 may have a columnar shape extending in the first direction D1.

The first shield pattern SL1 and the second shield pattern SL2 may be the first shield pattern SL1 and the second shield pattern SL2 in contact with each other as described with reference to FIGS. 2 and 3.

The first shield pattern SL1 and the second shield pattern SL2 may be replaced with the first shield pattern SL1a and the second shield pattern SL2a spaced apart from each other in the third direction D3 as described with reference to FIGS. 6A and 6B.

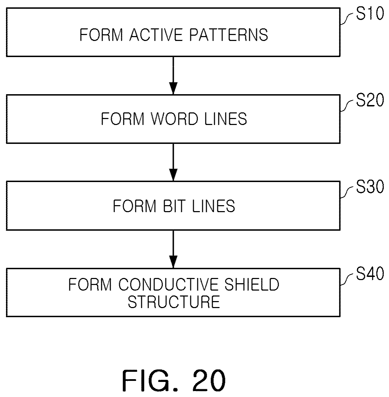

A method of manufacturing semiconductor devices 1, 100, and 200 described above with reference to FIGS. 1 to 19 will be described with reference to FIG. 20. FIG. 20 is a flowchart illustrating a method of manufacturing a semiconductor device according to an example embodiment.

Referring to FIG. 20, active patterns ACT, ACTa, and ACTb may be formed (S10).

In an example, the active patterns ACT and ACTa may be arranged in the first direction D1 and the second direction D2 perpendicular to each other.

In an example, the active patterns ACT and ACTb may be arranged three-dimensionally in the first direction D1, the second direction D2, and the third direction D3 perpendicular to each other.

Word lines WL may be formed (S20). The word lines WL may be formed after the active patterns ACT, ACTa, and ACTb are formed. Each of the word lines WL may extend in the second direction D2.

Each of the active patterns ACT, ACTa, and ACTb may include a first source/drain region SD1 and a second source/drain region SD2 spaced apart from each other in the third direction D3, and a channel region CH disposed between the first source/drain region SD1 and the second source/drain region SD2 and facing the word line WL.

Each of the active patterns ACT, ACTa, and ACTb may be formed to include at least one of the first offset region OS1 and the second offset region OS2 as described with reference to FIG. 7.

Bit lines BL may be formed (S30). The bit lines BL may be formed after the word lines WL are formed. Each of the bit lines BL may extend in the first direction D1. The bit lines BL may be connected to the first source/drain regions SD1 of the active patterns ACT, ACTa, and ACTb.

The conductive shield structures SLS, SLSa, 196, and SLSb may be formed (S40). The conductive shield structures SLS, SLSa, 196, and SLSb may be formed after the bit lines BL are formed. At least a portion of the conductive shield structures SLS, SLSa, 196, and SLSb may be formed between first and second bit lines adjacent to each other among the bit lines BL. The conductive shield structures SLS, SLSa, 196, and SLSb may include the first shield pattern SL1, SL1a, SL1b, 190, and 190a and the second shield pattern SL2, SL2a, SL2b, 192, and 192a as described above.

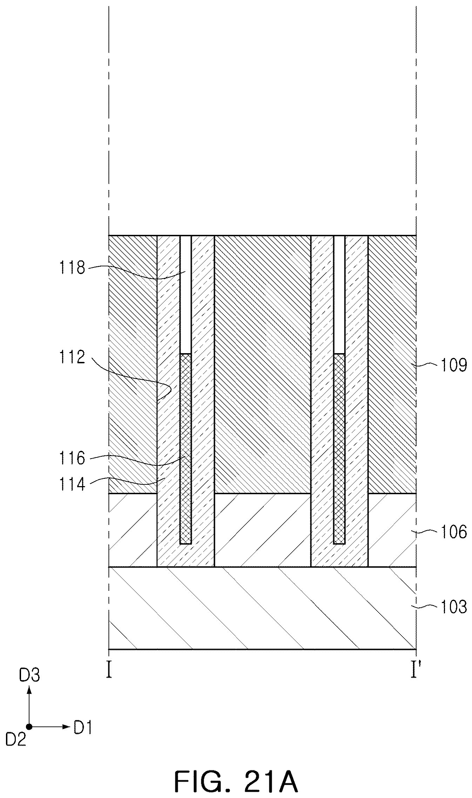

In the description below, a method of manufacturing the semiconductor device 100 described with reference to FIGS. 13, 14, and 15 will be described with reference to FIGS. 21A, 21B, 22A, 22B, 23A, 23B, 24A, 24B, 25A, and 25B. FIGS. 21A, 22A, 23A, 24A, and 25A are cross-sectional diagrams illustrating a region taken along line I-I' in FIG. 13, and FIGS. 21B, 22B, 23B, 24B, and 25B are cross-sectional diagrams illustrating a region taken along line II-II' in FIG. 13.

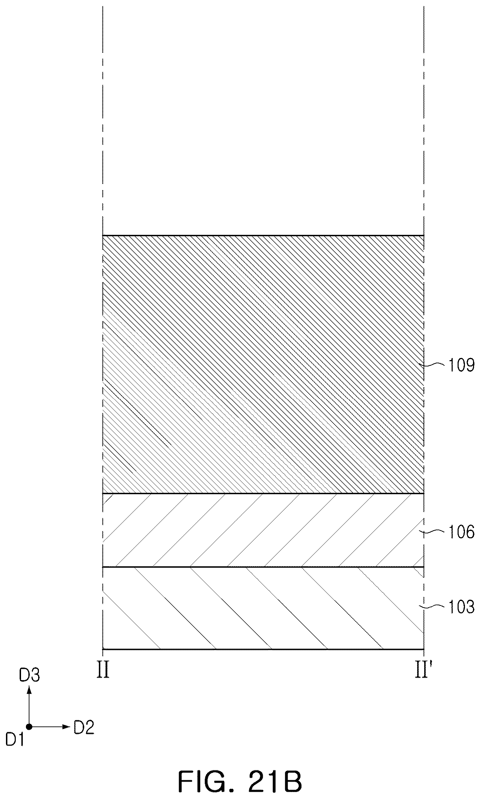

Referring to FIGS. 13, 21A, and 21B, a sacrificial substrate 103, a sacrificial insulating layer 106, and a semiconductor layer 109, stacked in order, may be formed. The semiconductor layer 109 may be formed of a semiconductor material, such as single crystal silicon. Trenches 112 penetrating the semiconductor layer 109 and the sacrificial insulating layer 106 may be formed. Each of the trenches 112 may have a line shape extending in the second direction D2. The semiconductor layers 109 may be spaced apart from each other in the first direction D1 by the trenches 112. A back gate dielectric layer 114 conformally covering inner walls of the trenches 112 may be formed, a back gate conductive layer may be formed on the back gate dielectric layer 114, forming preliminary back gate electrodes 116 partially filling the trenches 112 by etching a portion of the back gate conductive layer by an etch-back process, and first back gate capping patterns 118 filling other portions of the trenches 112 on the preliminary back gate electrodes 116 may be formed. The first back gate capping patterns 118 may be formed of an insulating material.

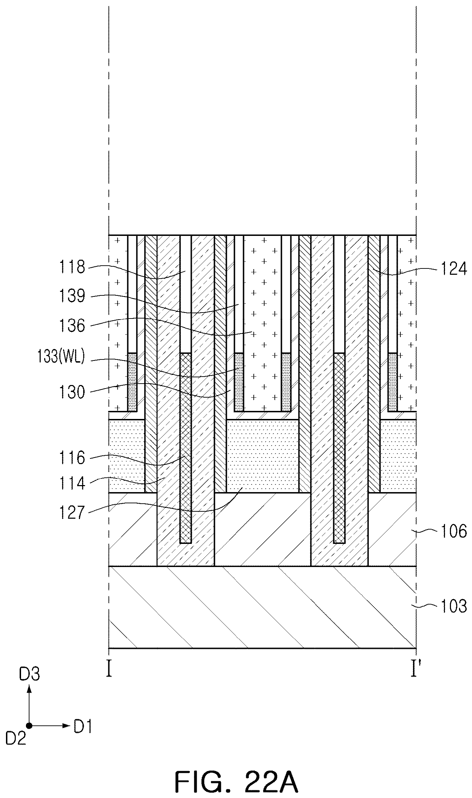

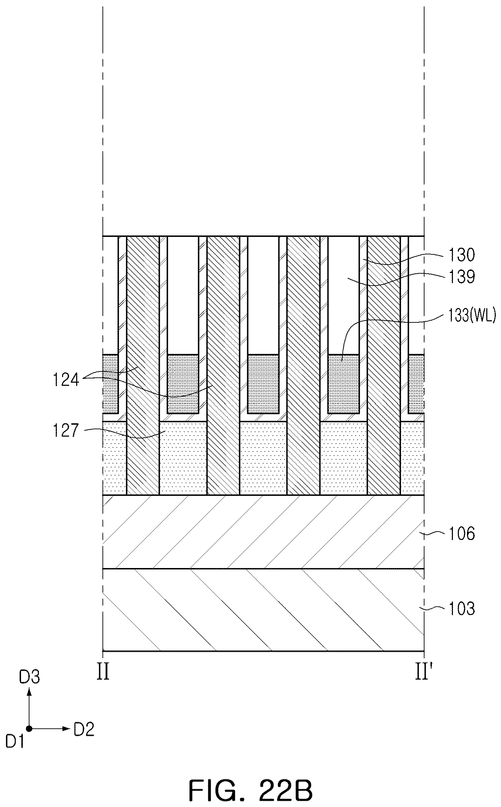

Referring to FIG. 13, FIGS. 22A and 22B, by patterning the semiconductor layers 109, active patterns 124 may be formed, and simultaneously, the sacrificial insulating layer 106 may be exposed. The semiconductor layers 109 may be patterned and may be formed as the active patterns 124.

Among the active patterns 124, a pair of active patterns adjacent to each other may be formed on both sides of one of the preliminary back gate electrodes 116. The insulating patterns 127 may be formed on the exposed sacrificial insulating layer 106. An upper surface of the insulating patterns 127 may be disposed at a level lower than upper surfaces of the preliminary back gate electrodes 116.

A gate dielectric layer 130 and gate electrodes 133 may be formed. The forming the gate dielectric layer 130 and the gate electrodes 133 may include forming a gate dielectric layer 130 conformally covering an upper surface of the insulating patterns 127 and exposed side surfaces of the active patterns 124, forming a preliminary gate conductive layer conformally covering the gate dielectric layer 130, anisotropically etching the preliminary gate conductive layers to form gate conductive layers, forming insulating isolation patterns 136 on the gate conductive layers, forming the gate electrodes 133 by etching a portion of the gate conductive layers, and forming gate capping patterns 139 on the gate electrodes 133. The gate electrodes 133 may be word lines WL. The upper surfaces of the active patterns 124, the insulating isolation patterns 136, and the gate capping patterns 139 may be coplanar with each other.

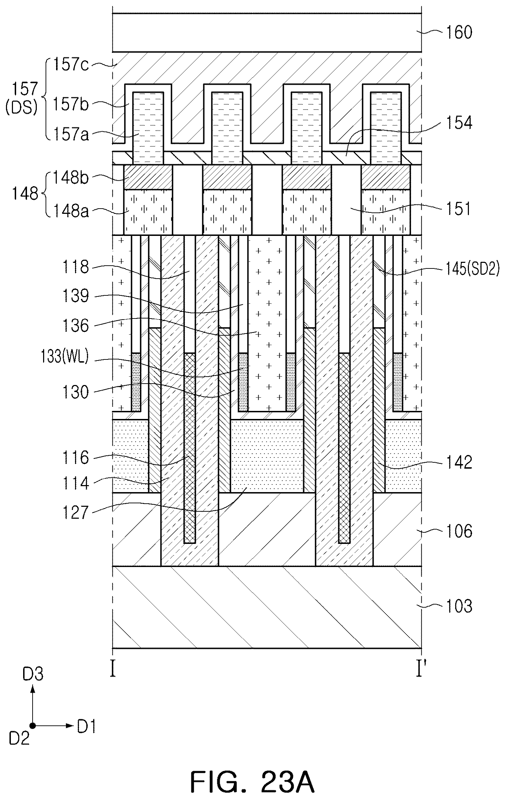

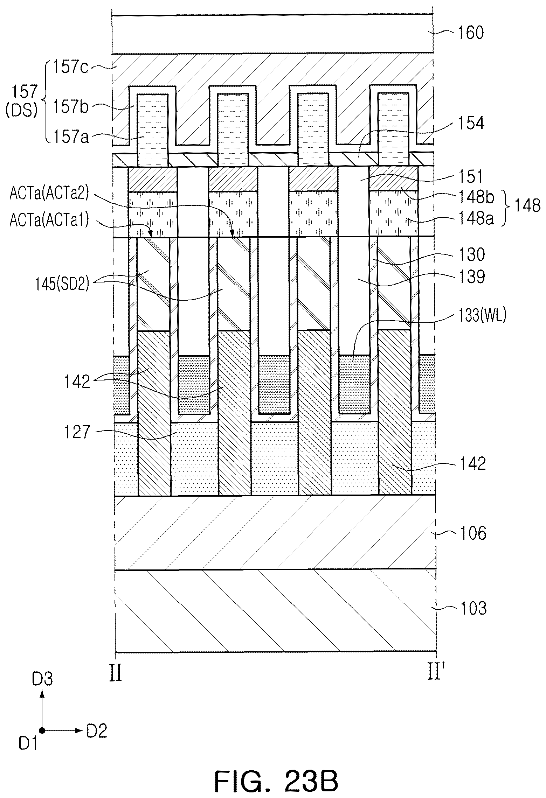

Referring to FIG. 13, FIGS. 23A and 23B, the second source/drain regions 145 may be formed in upper regions of the active patterns 124. The second source/drain regions 145 may be the second source/drain region SD2 of the cell transistor (cTR in FIG. 2) described above. The active patterns 124 remaining below the second source/drain regions 145 may be defined as undoped active regions 142.

In an example, the second source/drain regions 145 may be formed at a level higher than the word lines WL in order to form the second offset region (OS2 in FIGS. 14 and 15) described above.

The contact structures 148 and the insulating structure 151 may be formed. The contact structures 148 may be formed on the second source/drain regions SD2. The contact structures 148 may be connected to the second source/drain regions SD2. Each of the contact structures 148 may include a first material layer 148a and a second material layer 148b on the first material layer 148a. The first material layer 148a may include a material such as doped silicon. The second material layer 148b may include one of a metal, a metal nitride, and a metal-semiconductor compound. The insulating structure 151 may surround side surfaces of the contact structures 148.

An insulating etching stop layer 154 may be formed on the contact structures 148 and the insulating structure 151.

A data storage structure 157 including first electrodes 157a penetrating the insulating etching stop layer 154, connected to the contact structures 148 and extending upwardly, a dielectric layer 157b covering the first electrodes 157a and the etching stop layer 154, and a second electrode 157c covering the dielectric layer 157b may be formed. The data storage structure 157 may be the data storage structure DS of the memory cells (MC in FIG. 2) described above. An upper structure 160 may be formed on the data storage structure 157.

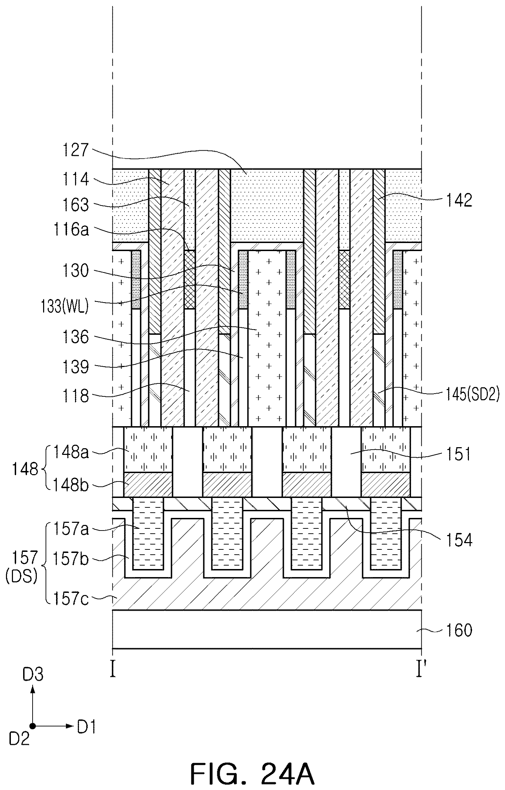

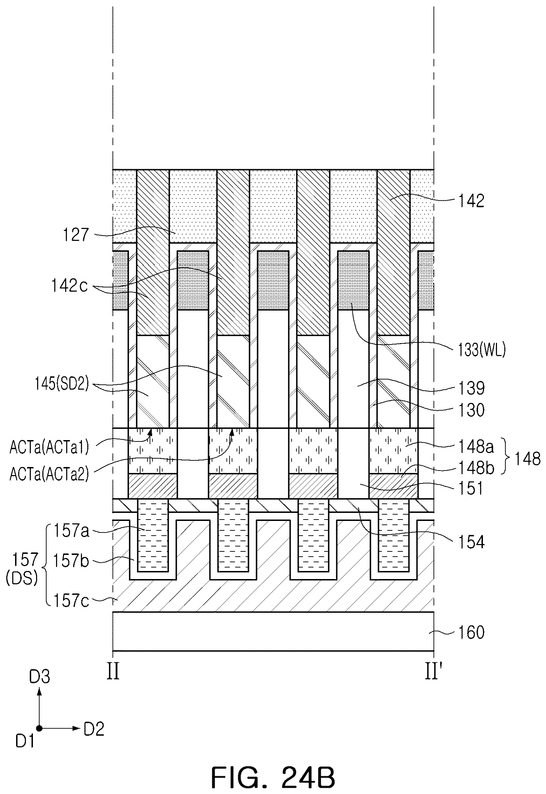

Referring to FIGS. 13, 24A and 24B, the upper structure 160 may be positioned in the downward direction, and the sacrificial substrate 103 and the sacrificial insulating layer 106 may be removed. Back gate electrodes 116a may be formed by etching a portion of the preliminary back gate electrodes 116, and second back gate capping patterns 163 may be formed on the back gate electrodes 116a. The insulating patterns 127 and the undoped active regions 142 may be exposed.

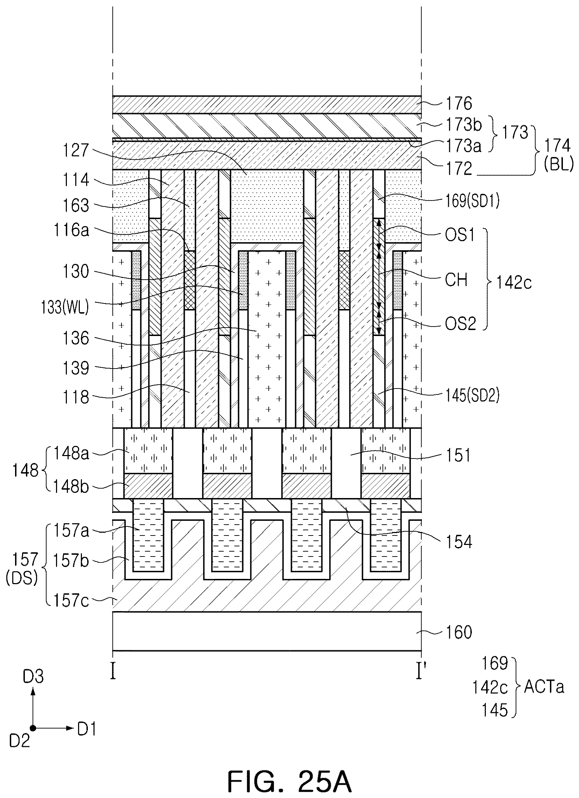

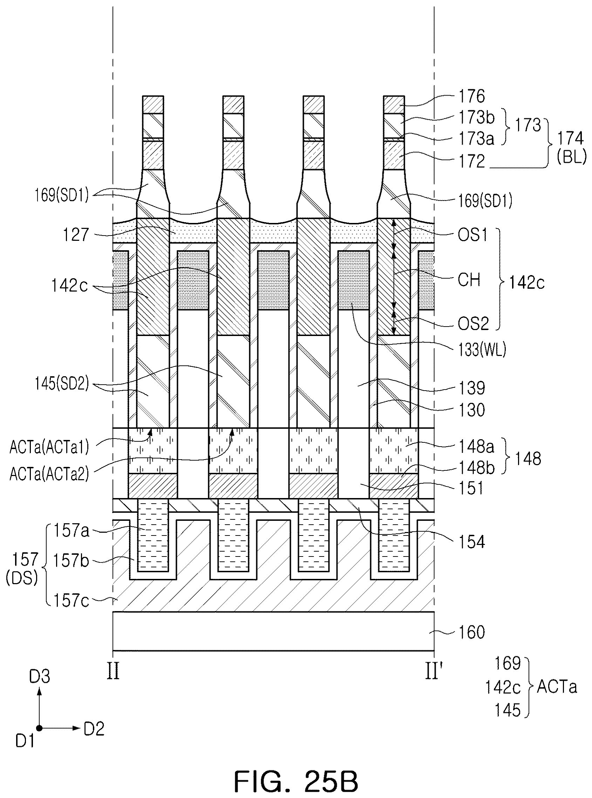

Referring to FIG. 13, FIG. 25A and 25B, first source/drain regions SD1 may be formed in the undoped active regions 142. Intermediate regions 142c may be formed between the first and second source/drain regions SD1 and SD2. Regions facing the word lines WL in the intermediate regions 142c may be defined as channel regions CH, and regions not facing the word lines WL may be defined as offset regions OS1 and OS2. The first and second source/drain regions SD1 and SD2 and the intermediate regions 142c may be formed in the active patterns ACTa.

Conductive lines 174 may be formed. The conductive lines 174 may be bit lines BL. The forming bit lines BL may include forming conductive material layers 172 and 173 stacked in order, forming insulating bit line capping patterns 176 on the conductive material layers 172 and 173, and forming the bit lines BL by performing an etching process using the bit line capping patterns 176 as an etching mask, and etching a portion of the insulating patterns 127 and a portion of the active patterns ACTa. The conductive material layers 172 and 173 may include a first material layer 172 and a second material layer 173 stacked in order. The first material layer 172 may include doped polysilicon. The second material layer 173 may include a 2-1 material layer 173a including at least one of a metal nitride and a metal-semiconductor compound, and a 2-2 material layer 173b formed on the 2-1 material layer 173a and including a metal. Each of the first source/drain regions SD1 may have a width the same as that of the bit line BL in a portion in contact with the bit line BL, and may have a shape in which the width may gradually increases in a direction from the portion in contact with the bit line BL toward the channel region CH.

Referring back to FIGS. 13, 14, and 15, a dielectric layer 179 may be conformally formed on a structure formed up to the bit lines BL and the bit line capping patterns 176. A conductive shield structure 196 may be formed on the dielectric layer 179. The forming the conductive shield structure 196 may include forming a first conductive material layer, forming first shield patterns 190 between the first source/drain regions SD1 adjacent to each other in the second direction by etching a portion of the first conductive material layer, and forming second conductive material layers 192 and 194. The second conductive material layer 192 and 194 may include second shield patterns 192 formed between the bit lines BL and a plate portion 194 formed on the bit line capping patterns 176 and extending from the second shield patterns 192.

In example embodiments, the dielectric layer 179 may be formed as dielectric layers 179a and 179b as in FIG. 16C.

According to an example embodiment, the first shield pattern 190 and the second shield pattern 192 may be formed as the first shield pattern 190a and the second shield pattern 192a spaced apart from each other in the third direction D3 as in FIG. 16D. In this case, an isolation dielectric layer 191 may be formed between the first shield pattern 190a and the second shield pattern 192a.

According to an example embodiment, the first shield pattern 190 and the second shield pattern 192 may be formed as first shield pattern 190a and second shield pattern 192a spaced apart from each other in the third direction D3 as in FIG. 16E, and the dielectric layer 179 may be formed as dielectric layers 181 and 183 as in FIG. 16E.

According to the aforementioned example embodiments, a conductive shield structure which may prevent electrical interference occurring between memory cells adjacent to each other, for example, characteristics of memory cells by capacitance coupling, from being degraded may be provided.

Also, the conductive shield structure may prevent characteristics of operating memory cells from being degraded by other bit lines in the vicinity.

Also, the conductive shield structure may reduce parasitic capacitance between adjacent bit lines by reducing capacitance coupling occurring between adjacent bit lines, thereby preventing a signal transmission speed of the bit lines from being reduced by bit lines adjacent to each other.

Also, an active pattern including an offset region disposed between a channel region and a source/drain region may be provided. The offset region may be an undoped region. The offset region may prevent characteristics of memory cells from being degraded by gate-induced-drain leakage (GIDL).

Also, the conductive shield structure and the offset region may improve performance of a semiconductor device.
Embodiments are set out in the following clauses:
Clause 1. A semiconductor device, comprising: a first bit and a second bit line each extending in a first direction and adjacent to each other in a second direction perpendicular to the first direction; a first active pattern and a second active pattern each including a first region, a second region, and a channel region between the first and second regions, wherein the first region of the first active pattern is connected to the first bit line in a third direction perpendicular to the first and second directions, and the first region of the second active pattern is connected to the second bit line in the third direction; a word line facing the channel regions of the first and second active patterns; and a conductive shield structure disposed between the first bit line and the second bit line, and between the first region of the first active pattern and the first region of the second active pattern.
Clause 2. The semiconductor device of Clause 1, wherein a portion of the conductive shield structure is disposed between the channel region of the first active pattern and the second bit line, and between the channel region of the second active pattern and the first bit line.
Clause 3. The semiconductor device of Clause 1 or 2, wherein the conductive shield structure includes: a first shield pattern disposed between the first region of the first active pattern and the first region of the second active pattern; and a second shield pattern disposed between the first bit line and the second bit line.
Clause 4. The semiconductor device of Clause 3, wherein the first shield pattern has a first surface in contact with the second shield pattern and a second surface opposing the first surface in the third direction.
Clause 5. The semiconductor device of Clause 3 or 4, wherein the first shield pattern includes a first material having a first work function, and wherein the second shield pattern includes a second material having a second work function, and wherein the second work function is greater than the first word function.
Clause 6. The semiconductor device of Clause 3, 4 or 5, wherein the second shield pattern is spaced apart from the first shield pattern in the third direction.
Clause 7. The semiconductor device of Clause 6, further comprising: a first circuit electrically connected to the first shield pattern and configured to apply a first voltage to the first shield pattern; and a second circuit electrically connected to the second shield pattern and configured to apply a second voltage different from the first voltage to the second shield pattern.
Clause 8. The semiconductor device of any preceding Clause, further comprising: a first dielectric layer between the conductive shield structure and the first region of the first active pattern, and between the conductive shield structure and the first region of the second active pattern; and a second dielectric layer between the conductive shield structure and the first bit line, and between the conductive shield structure and the second bit line, wherein the first dielectric layer and the second dielectric layer have different dielectric constants.
Clause 9. The semiconductor device of Clause 8, wherein a dielectric constant of the first dielectric layer is greater than a dielectric constant of the second dielectric layer.
Clause 10. The semiconductor device of any preceding Clause, further comprising: a dielectric layer between the conductive shield structure and the first region of the first active pattern, and between the conductive shield structure and the first region of the second active pattern; a first air gap between the conductive shield structure and the first bit line; and a second air gap between the conductive shield structure and the second bit line.
Clause 11. The semiconductor device of any preceding Clause, wherein each of the first and second active patterns includes a single crystal silicon layer, an oxide semiconductor layer, or a two-dimensional material layer having semiconductor properties.
Clause 12. The semiconductor device of any preceding Clause, wherein a minimum width of the channel region of the first active pattern is greater than a minimum width of the first region of the first active pattern in the second direction.
Clause 13. The semiconductor device of any preceding Clause, wherein each of the first and second active patterns further includes at least one of a first offset region between the channel region and the first region, and a second offset region between the channel region and the second region, wherein the word line does not face the first and second offset regions, wherein each of the first and second regions has N-type conductivity, and wherein each of the channel region, the first offset region, and the second offset region is an undoped region.
Clause 14. A semiconductor device, comprising: a first bit line and a second bit line each extending in a first direction and adjacent to each other in a second direction perpendicular to the first direction; a first active pattern and a second active pattern each including a first region, a second region, and a channel region between the first and second regions, wherein the first region of the first active pattern is connected to the first bit line in a third direction perpendicular to the first and second directions, and the first region of the second active pattern is connected to the second bit line in the third direction; a word line facing the channel regions of the first and second active patterns; and a conductive shield structure disposed between the first bit line and the second bit line, and between the first region of the first active pattern and the first region of the second active pattern, wherein the conductive shield structure includes: a first shield pattern between the first region of the first active pattern and the first region of the second active pattern; and a second shield pattern between the first and second bit lines, wherein the first shield pattern includes a first material having a first work function, and wherein the second shield pattern includes a second material having a second work function, and wherein the second work function is different from the first word function.
Clause 15. The semiconductor device of Clause 14, wherein the first shield pattern has a first surface in contact with the second shield pattern and a second surface opposing the first surface in the third direction.
Clause 16. The semiconductor device of Clause 14 and 15, wherein the second work function of the second material of the second shield pattern is greater than the first work function of the first material of the first shield pattern.
Clause 17. The semiconductor device of Clause 14, 15 and 16, wherein the conductive shield structure further includes a plate portion extending from the second shield pattern and overlapping the first and second bit lines in the third direction.
Clause 18. A semiconductor device, comprising: a first structure including cell active patterns, bit lines, word lines, and a conductive shield structure; and a second structure disposed on and bonded to the first structure, wherein the second structure includes a bit line sense amplifier electrically connected to the bit lines, a sub-word line driver electrically connected to the word lines, and a voltage control circuit electrically connected to the conductive shield structure, wherein each of the bit lines extends in a first direction, wherein the bit lines include a first bit line and a second bit line adjacent to each other in a second direction perpendicular to the first direction, wherein each of the active patterns includes a first source/drain region and a second source/drain region spaced apart from each other in a third direction, and a channel region between the first and second source/drain regions, wherein the third direction is perpendicular to the first and second directions, wherein the word lines face the channel regions of the active patterns adjacent to the word lines, wherein the active patterns include a first active pattern connected to the first bit line and a second active pattern connected to the second bit line, wherein the first source/drain region of the first active pattern is connected to the first bit line in the third direction, wherein the first source/drain region of the second active pattern is connected to the second bit line in the third direction, and wherein the conductive shield structure includes a first shield pattern disposed between the first source/drain region of the first active pattern and the first source/drain region of the second active pattern.
Clause 19. The semiconductor device of Clause 18, wherein the conductive shield structure further includes a second shield pattern disposed between the first bit line and the second bit line.
Clause 20. The semiconductor device of Clause 19, further including: a first dielectric layer between the first shield pattern and the first source/drain region of the first active pattern, and between the first shield pattern and the first source/drain region of the second active pattern; and a second dielectric layer between the second shield pattern and the first bit line, and between the second shield pattern and the second bit line, wherein the first dielectric layer and the second dielectric layer have different dielectric constants.

While the example embodiments have been illustrated and described above, it will be configured as apparent to those skilled in the art that modifications and variations could be made without departing from the scope of the present disclosure as defined by the appended claims.

## Claims

1. A semiconductor device (1), comprising:
a first bit line (BL1) and a second bit line (BL2) each extending in a first direction (D1) and adjacent to each other in a second direction (D2) perpendicular to the first direction (D1);
a first active pattern (ACT1) and a second active pattern (ACT2) each including a first region (SD1), a second region (SD2), and a channel region (CH) between the first (SD1) and second regions (SD2), wherein the first region (SD1) of the first active pattern (ACT1) is connected to the first bit line (BL1) in a third direction (D3) perpendicular to the first (D1) and second directions (D2), and the first region (SD1) of the second active pattern (AP2) is connected to the second bit line (BL2) in the third direction (D3);
a word line (WL) facing the channel regions (CH) of the first (AP1) and second (AP2) active patterns; and
a conductive shield structure (SLS) disposed between the first bit line (BL1) and the second bit line (BL2), and between the first region (SD1) of the first active pattern (AP1) and the first region (SD1) of the second active pattern (AP2).

2. The semiconductor device of claim 1, wherein a portion of the conductive shield structure (SLS) is disposed between the channel region (CH) of the first active pattern (AP1) and the second bit line (BL2), and between the channel region (CH) of the second active pattern (AP2) and the first bit line (BL1).

3. The semiconductor device of claim 1 or 2, wherein the conductive shield structure (SLS) includes:
a first shield pattern (SL1) disposed between the first region (SD1) of the first active pattern (AP1) and the first region (SD1) of the second active pattern (AP2); and
a second shield pattern (SL2) disposed between the first bit line (BL1) and the second bit line (BL2).

4. The semiconductor device of claim 3, wherein the first shield pattern (SL1) has a first surface (S1) in contact with the second shield pattern (SL2) and a second surface (S2) opposing the first surface (S1) in the third direction (D3).

5. The semiconductor device of claim 3 or 4, wherein the first shield pattern (SL1) includes a first material, and
wherein the second shield pattern (SL2) includes a second material different from the first material (SL1).

6. The semiconductor device of claim 3, 4 or 5, wherein the first shield pattern (SL1) has a first work function,
wherein the second shield pattern (SL2) has a second work function, and
wherein the second work function is greater than the first work function.

7. The semiconductor device of any one of claims 3 to 6, wherein the first shield pattern (SL1) includes a first material having a first work function, and
wherein the second shield pattern (SL2) includes a second material having a second work function, and
wherein the second work function is greater than the first work function.

8. The semiconductor device of any one of claims 3 to 7, wherein the second shield pattern (SL2) is spaced apart from the first shield pattern (SL1) in the third direction (D3).

9. The semiconductor device of claim 8, further comprising:
a first circuit electrically (VC1) connected to the first shield pattern (SL1) and configured to apply a first voltage to the first shield pattern (SL1); and
a second circuit (VC2) electrically connected to the second shield pattern (SL2) and configured to apply a second voltage different from the first voltage to the second shield pattern (SL2).

10. The semiconductor device of any preceding claim, further comprising:
a first dielectric layer (12) between the conductive shield structure (SLS) and the first region (SD1) of the first active pattern (AP1), and between the conductive shield structure (SLS) and the first region (SD1) of the second active pattern (AP2); and
a second dielectric layer (15) between the conductive shield structure (SLS) and the first bit line (BL1), and between the conductive shield structure (SLS) and the second bit line (BL2),
wherein the first dielectric layer (12) and the second dielectric layer (15) have different dielectric constants.

11. The semiconductor device of claim 10, wherein a dielectric constant of the first dielectric layer (12) is greater than a dielectric constant of the second dielectric layer (15).

12. The semiconductor device of any preceding claim, further comprising:
a dielectric layer between the conductive shield structure (SLS) and the first region (SD1) of the first active pattern (AP1), and between the conductive shield structure (SLS) and the first region (SD1) of the second active pattern (AP2);
a first air gap (18a) between the conductive shield structure (SLS) and the first bit line (BL1); and
a second air gap (18b) between the conductive shield structure (SLS) and the second bit line (BL2).

13. The semiconductor device of any preceding claim, wherein each of the first (AP1) and second (AP2) active patterns includes a single crystal silicon layer, an oxide semiconductor layer, or a two-dimensional material layer having semiconductor properties.

14. The semiconductor device of any preceding claim, wherein a minimum width of the channel region (CH) of the first active pattern (AP1) is greater than a minimum width of the first region (SD1) of the first active pattern (AP1) in the second direction (D2).

15. The semiconductor device of any preceding claim, wherein each of the first (AP1) and second (AP2) active patterns further includes at least one of a first offset region (OS1) between the channel region (CH) and the first region (SD1), and a second offset region (OS2) between the channel region (CH) and the second region (SD2),
wherein the word line (WL) does not face the first (O 1) and second (OS2) offset regions,
wherein each of the first (SD1) and second (SD2) regions has N-type conductivity, and
wherein each of the channel region (CH), the first offset region (OS1), and the second offset region (OS2) is an undoped region.
